# EUROPEAN PATENT APPLICATION

(11) **EP 1 324 594 A2**
(43) Date of publication of application: **02.07.2003**
(21) Application number: 02258345.4
(22) Date of filing: 03.12.2002
(51) Int. Cl.: H04N 5/225, G03B 15/00, H01L 31/0203

(54) **Image pickup unit and electronic apparatus**

(30) Priority: 14.12.2001 JP 2001381978; 27.12.2001 JP 2001395873; 24.01.2002 JP 2002015381
(71) Applicant: KONICA CORPORATION, Tokyo 163-0512 (JP)
(72) Inventor: Tansho, Kazuo c/o Konica Corporation, Tokyo 192-8505 (JP); Mizukami, Masafumi c/o Konica Corporation, Tokyo 192-8505 (JP); Atarashi, Yuichi c/o Konica Corporation, Tokyo 192-8505 (JP); Ito, Keiichi, Yamagat-ken 991-0061 (JP); Mitobe, Kenji, Yamagata-ken 990-0703 (JP)
(74) Representative: Nicholls, Michael John

(57) **Abstract**

An image pickup unit comprising: an image pickup substrate having an image pickup element; a case body for containing the image pickup substrate therein; a communicating connection for transmitting image information obtained by the image pickup element to an outside of the case body, the communicating connection being connected with the image pickup substrate; a pivotally supporting part for pivotally supporting the case body and for arranging the communicating connection extending from the case body in the pivotally supporting part; and a slit portion for guiding the communicating connection to an outside of the pivotally supporting part, the slit portion being formed on a peripheral surface of the pivotally supporting part; wherein the communicating connection comprises an axial direction extension part extending in a rotational axis direction of the case body from the case body to the pivotally supporting part; a bent part formed on an end portion of the axial direction extension part to bend the communicating connection in the pivotally supporting part to a direction which is approximately perpendicular to the rotational axis direction; and an extending part extending to the outside of the pivotally supporting part through the slit portion.

## Description

### BACKGROUND OF THE INVENTION

### Field of the Invention

The present invention relates to an image pickup unit comprising a communicating connection for transmitting image information of a photographic subject, which is obtained by an image pickup element; and an electronic apparatus comprising the above image pickup unit.

### Description of Related Art

In recent years, an electronic apparatus, such as a portable telephone and the like, comprising an image pickup unit has been known. The image pickup unit comprises a case body in which an image pickup substrate having an image pickup element is provided. The case body is fixedly attached to the main body of the electronic apparatus. One end of the communicating connection for transmitting image information obtained by the image pickup element is connected with the image pickup substrate . The communicating connection is made of a flexible substrate. The other end of the communicating connection is connected with a processing part of the electronic apparatus. Therefore, the image information obtained by the image pickup element is displayed on a display part of the electronic apparatus.

However, in the above-described the image pickup unit, because the case body is fixedly attached to the main body of the electronic apparatus, a user of the electronic apparatus must move the image pickup unit with the electronic apparatus. The operation for picking up an image is extremely troublesome. Therefore, it is thought that the case body of the image pickup unit is rotatable. However, if the electronic apparatus has a structure that the case body is rotatable, an undue load, such as bending, torsion or the like, is applied to the communicating connection connected with the image pickup substrate by the rotation of the case body. As a result, there is some possibility that the communicating connection is broken.

### SUMMARY OF THE INVENTION

In order to solve the above-described problems, an object of the present invention is to provide an image pickup unit in which the case body of the image pickup unit is rotatable in accordance with the position of the photographic subject and in which the load to be applied to the communicating connection by the rotation of the case body can be reduced; and an electronic apparatus comprising the above-described image pickup unit.

That is, in accordance with the first aspect of the present invention, an image pickup unit comprises:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a bent part formed on an end portion of the axial direction extension part to bend the communicating connection in the pivotally supporting part to a direction which is approximately perpendicular to the rotational axis direction; and an extending part extending to the outside of the pivotally supporting part through the slit portion.

In the specification, the phase "communicating connection" means all ones which can transmit the image information obtained by the image pickup element outside. As a communicating connection, a flexible substrate, a flexible wire and the like are exemplified.

The phase "pivotally supporting part" means all ones which can pivotally support the case body and can arrange the communicating connection extending from the case body therein. Any shape of the pivotally supporting part can be adopted.

According to the image pickup unit, the user or the like of the image pickup unit can pick up an image of a photographic subject by rotating the case body with respect to the pivotally supporting part fixed to, for example, a main body of an electronic apparatus or the like, in accordance with the position of the photographic subject and the like. That is, the user or the like is not required to move the image pickup unit with the electronic apparatus or the like in the image pickup of the photographic subject. As a result, it is extremely advantageous for practical use.

Then, because the extending part side of the communicating connection is expanded to a longitudinal direction by rotating the case body, a load, such as torsion, is not applied to the axial direction extension part side. Thereby, it is possible to reduce the load to be applied to the communicating connection and to improve the reliability of the communicating connection exponentially.

By bending one connection part of the communicating connection, which extends to a predetermined direction, the axial direction extension part, the bent part and the extending part can be easily formed. Therefore, it is possible to reduce the manufacturing cost.

In the image pickup unit, the pivotally supporting part comprises a contact member for contacting with the bent part of the communicating connection; and
the bent part of the communicating connection may be formed by contacting the communicating connection with the contact member to bend the communicating connection.

According to the image pickup unit, it is possible to bend the communicating connection by using the contact member and to form the bent part adequately. Further, because the shape of the bent part can be kept by the contact member, there is no possibility that the stress to be caused by deforming the bent part in accordance with the rotation of the case body, is concentrated. Thereby, it is possible to improve the reliability of the communicating connection exponentially.

In accordance with the second aspect of the present invention, an image pickup unit comprises:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a perpendicular direction extension part connected with an end portion of the axial direction extension part and extending to a direction which is approximately perpendicular to the rotational axis direction; and an extending part extending to the outside of the pivotally supporting part through the slit portion.

According to the image pickup unit, the user or the like of the image pickup unit can pick up an image of a photographic subject by rotating the case body with respect to the pivotally supporting part fixed to, for example, a main body of an electronic apparatus or the like, in accordance with the position of the photographic subject and the like. That is, the user or the like is not required to move the image pickup unit with the electronic apparatus or the like in the image pickup of the photographic subject. As a result, it is extremely advantageous for practical use.

Then, because the extending part side of the communicating connection is expanded to a longitudinal direction by rotating the case body, a load, such as torsion, is not applied to the axial direction extension part side. Thereby, it is possible to reduce the load to be applied to the communicating connection and to improve the reliability of the communicating connection exponentially.

The communicating connection is easily formed by connecting the axial direction extension part with the perpendicular direction extension part. Therefore, it is possible to reduce the manufacturing cost.

In the image pickup unit, the axial direction extension part and the perpendicular direction extension part may be unitedly formed.

According to the image pickup unit, because the axial direction extension part and the perpendicular direction extension part are unitedly formed, the strength of the joint portion between the axial direction extension part and the perpendicular direction extension part can be improved exponentially. That is, because the direction to which the communicating connection extends is changed by about 90° at the joint portion, the stress is concentrated on the joint portion by rotating the case body. However, the joint portion is effectively strengthened against the stress and the like. Further, it is possible to improve the reliability of the communicating connection.

Because the axial direction extension part and the perpendicular direction extension part of the communicating connection are unitedly formed, it is possible to reduce the manufacturing cost.

In the image pickup unit, the pivotally supporting part may comprise a plurality of slit portions; and
the communicating connection may comprise a plurality of extending parts which are formed so as to correspond to each slit portion.

According to the image pickup unit, the image information and the like obtained by the image pickup unit are transmitted to the outside of the pivotally supporting part through a plurality of extending parts of the communicating connection. That is, by a plurality of extending parts, quantities of image information and the like can be transmitted.

Further, because the communicating connection comprises a plurality of extending parts, a width of one extending part can be narrowed. The load to be applied to the extending parts extending in accordance with the rotation of the case body, can be dispersed.

In the image pickup unit, the slit portion may be formed so as to extend to the rotational axis direction of the case body.

According to the image pickup unit, the torsion force is not applied to the extending part of the communicating connection by rotating the case body. Therefore, the reliability of the communicating connection is improved.

In the image pickup unit, the communicating connection may comprise a circumferential direction extension part extending to a circumferential direction of the pivotally supporting part in the pivotally supporting part.

According to the image pickup unit, the circumferential direction of the communicating connection is curved in the pivotally supporting part to penetrate through the slit portion along the circumferential direction. That is, when the case body is rotated, the bending deformation is not extremely caused to a portion of the communicating connection, which penetrates through the slit portion. As a result, the bending stress and the like are not extremely applied to the portion of the communicating connection, which penetrates through the slit portion. Therefore, there is no possibility that the extending part of the communicating connection is broken by applying the extreme bending stress and the like to the portion of the communicating connection, which penetrates through the slit portion, repeatedly. It is possible to improve the reliability of the communicating connection more.

In the image pickup unit, the axial direction extension part of the communicating connection may be formed apart from the rotational axis of the case body toward a radial direction of the pivotally supporting part.

According to the image pickup unit, the circumferential direction extension part of the communicating connection can be gently curved in the pivotally supporting part by using the space apart from the rotational axis. As a result, a portion of the circumferential direction extendingpart, which is shapely curved, is not formed. Therefore, the stress and the like are not concentrated on the specific portion of the circumferential direction extension part. It is possible to improve the reliability of the communicating connection more.

In the image pickup unit, at least a portion of the circumferential direction extension part of the communicating connection may be fixed to an inner surface of the pivotally supporting part; and
the communicating connection may be expanded to the outside of the pivotally supporting part by rotating the case body.

According to the image pickup unit, because the communicating connection is expanded to the outside of the pivotally supporting part by rotating the case body, the communicating connection is not expanded in the pivotally supporting part. That is, the circumferential direction extension part and the like of the communicating connection, which are curved in the pivotally supporting part, are not deformed by rotating the case body. Therefore, the load is not applied to the curved portion and the like of the communicating connection. It is possible to improve the reliability of the communicating connection more.

In the image pickup unit, the circumferential direction extension part of the communicating connection may be formed so as to be wound in the pivotally supporting part; and
the communicating connection may be expanded in the pivotally supporting part by rotating the case body.

According to the image pickup unit, because the communicating connection is expanded in the pivotally supporting part by rotating the case body, the communicating connection is not expanded out of the pivotally supporting part. Therefore, the position of the end portion of the extending part side of the communicating connection is not changed. It is not necessary that a processing part or the like of the electronic apparatus, which is connected with the end portion of the communicating connection on the extending part side, has a structure which copes with the expansion of the communicating connection. As a result, it is extremely advantageous when the electronic apparatus or the like having the image pickup unit is designed.

In the image pickup unit, among the communicating connection, at least the circumferential direction extension part may be made of a flexible substrate.

According to the image pickup unit, the load, such as torsion or the like, is not applied to each part of the plate-like flexible substrate. In the image pickup unit in which the case body is rotated, the plate-like flexible substrate can be used. It is extremely advantageous for practical use.

In the image pickup unit, among the communicating connection, at least a portion from the axial direction extension part to the extending part may be made of a flexible substrate.

According to the image pickup unit, the load, such as torsion or the like, is not applied to each part of the plate-like flexible substrate. In the image pickup unit in which the case body is rotated, the plate-like flexible substrate can be used. It is extremely advantageous for practical use.

In the image pickup unit, the flexible substrate may be arranged so that a width direction of the extending part coincides with the rotational axis direction of the case body; and
the slit portion may be formed so as to extend the slit portion to the rotational axis direction of the case body in accordance with a width of the extending part of the flexible substrate.

According to the image pickup unit, the torsion force is not applied to the extending part of the flexible substrate by rotating the case body. The flexible substrate is bent in a thickness direction in which the flexural rigidity is relatively small. Therefore, the reliability of the flexible substrate is improved. The flexible substrate is allowed to be bent when the case body is rotated. It is possible to rotate the case body smoothly.

In the image pickup unit, the pivotally supporting part may be formed in an approximately cylindrical shape; and
a flat portion may be formed on the peripheral surface of the pivotally supporting part.

According to the image pickup unit, by using the flat portion of the pivotally supporting part, the image pickup unit can be easily fixed to or engaged with, for example an electronic apparatus or the like. That is, when the image pickup unit is incorporated into the electronic apparatus or the like, the position of the approximately cylindrical pivotally supporting part with respect to the electronic apparatus or the like can be precisely determined by using the flat portion as a reference. Further, in the pivotally supporting part formed into an approximately cylindrical shape, for example, by providing a contact portion for contacting with the flat portion on the electronic apparatus side, the rotation of the pivotally supporting part can be regulated easily and reliably.

In accordance with the third aspect of the present invention, an image pickup unit comprises:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a case shaft part for arranging the communicating connection which extends to the outside of the case body;
a pivotally supporting part for pivotally supporting the case shaft part and for arranging the communicating connection extending from the case shaft part in the pivotally supporting part; and
a slit portion for guiding the communicating connection to an outside of the pivotally supporting part, the slit portion being formed on a peripheral surface of the pivotally supporting part;
wherein the image pickup unit has a cantilever structure that the case body is supported by only the pivotally supporting part; and
the communicating connection comprises an axial direction extension part extending to a rotational axis direction of the case body from the case body to the pivotally supporting part; a bent part formed on an end portion of the axial direction extension part to bend the communicating connection in the pivotally supporting part to a direction which is approximately perpendicular to the rotational axis direction; and an extending part extending to the outside of the pivotally supporting part through the slit portion.

According to the image pickup unit, because the communicating connection is arranged in the case shaft part which is pivotally supported by the pivotally supporting part, the communicating connection can be guided to the outside by using the case shaft part without forming a guide member or the like for guiding the communicating connection to the outside. That is, the image pickup unit can be formed more freely. The case body and the like can be easily formed. It is advantageous for design and manufacturing.

Because the image pickup unit has a cantilever structure that the case body is supported by the pivotally supporting part, the image pickup unit can be rotatably fixed to an electronic apparatus or the like, such as a portable telephone, by fixing the electronic apparatus or the like only to the pivotally supporting part. Therefore, the image pickup unit is easily incorporated into the electronic apparatus or the like. As compared with the image pickup unit in which the both sides of case body are fixed to the electronic apparatus or the like, the image pickup unit and the electronic apparatus or the like to which the image pickup unit is fixed, are designed more freely.

The user or the like of the image pickup unit can pick up the image of a photographic subject by rotating the case body with respect to the pivotally supporting part fixed to, for example, a main body of an electronic apparatus or the like, in accordance with the position of the photographic subject and the like. That is, the user or the like is not required to move the image pickup unit with the electronic apparatus or the like in the image pickup of the photographic subject. As a result, it is extremely advantageous for practical use.

Then, because the extending part side of the communicating connection is expanded to a longitudinal direction by rotating the case body, a load, such as torsion, is not applied to the axial direction extension part side. Thereby, it is possible to reduce the load to be applied to the communicating connection and to improve the reliability of the communicating connection exponentially.

By bending one connection part of the communicating connection, which extends to a predetermined direction, the axial direction extension part, the bent part and the extending part can be easily formed. Therefore, it is possible to reduce the manufacturing cost.

In accordance with the fourth aspect of the present invention, an image pickup unit comprises:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a case shaft part for arranging the communicating connection which extends to the outside of the case body;
a pivotally supporting part for pivotally supporting the case shaft part and for arranging the communicating connection extending from the case shaft part in the pivotally supporting part; and
a slit portion for guiding the communicating connection to an outside of the pivotally supporting part, the slit portion being formed on a peripheral surface of the pivotally supporting part;
wherein the image pickup unit has a cantilever structure that the case body is supported by only the pivotally supporting part; and
the communicating connection comprises an axial direction extension part extending to a rotational axis direction of the case body from the case body to the pivotally supporting part; a perpendicular direction extension part connected with an end portion of the axial direction extension part and extending to a direction which is approximately perpendicular to the rotational axis direction; and an extending part extending to the outside of the pivotally supporting part through the slit portion.

According to the image pickup unit, because the communicating connection is arranged in the case shaft part which is pivotally supported by the pivotally supporting part, the communicating connection can be guided to the outside by using the case shaft part without forming a guide member or the like for guiding the communicating connection to the outside. That is, the image pickup unit can be formed more freely. The case body and the like can be easily formed. It is advantageous for design and manufacturing.

Because the image pickup unit has a cantilever structure that the case body is supported by the pivotally supporting part, the image pickup unit can be rotatably fixed to an electronic apparatus or the like, such as a portable telephone, by fixing the electronic apparatus or the like only to the pivotally supporting part. Therefore, the image pickup unit is easily incorporated into the electronic apparatus or the like. As compared with the image pickup unit in which the both sides of case body are fixed to the electronic apparatus or the like, the image pickup unit and the electronic apparatus or the like to which the image pickup unit is fixed, are designedmore freely.

The user or the like of the image pickup unit can pick up an image of a photographic subject by rotating the case body with respect to the pivotally supporting part fixed to, for example, a main body of an electronic apparatus or the like, in accordance with the position of the photographic subject and the like. That is, the user or the like is not required to move the image pickup unit with the electronic apparatus or the like in the image pickup of the photographic subject. As a result, it is extremely advantageous for practical use.

Then, because the extending part side of the communicating connection is expanded to a longitudinal direction by rotating the case body, a load, such as torsion, is not applied to the axial direction extension part side. Thereby, it is possible to reduce the load to be applied to the communicating connection and to improve the reliability of the communicating connection exponentially.

The communicating connection is easily formed by connecting the axial direction extension part with the perpendicular direction extension part. Therefore, it is possible to reduce the manufacturing cost.

In the image pickup unit, the axial direction extension part and the perpendicular direction extension part may be unitedly formed.

According to the image pickup unit, because the axial direction extension part and the perpendicular direction extension part are unitedly formed, the strength of the joint portion between the axial direction extension part and the perpendicular direction extension part can be improved exponentially. That is, because the direction to which the communicating connection extends is changed by about 90° at the joint portion, the stress is concentrated on the joint portion by rotating the case body. However, the joint portion is effectively strengthened against the stress and the like. Further, it is possible to improve the reliability of the communicating connection.

Because the axial direction extension part and the perpendicular direction extension part of the communicating connection are unitedly formed, it is possible to reduce the manufacturing cost.

In the image pickup unit, the pivotally supporting part may be divided into at least two block bodies arranged in the rotational axis direction of the case body.

According to the image pickup unit, because the pivotally supporting part is divided into at least two block bodies arranged in the rotational axis direction of the case body, the case body can be pivotally supported by a block body which is the closest to the case body (hereinafter, referred to as "closest block body) . The extending part side of the communicating connection can be arranged in the block bodies except the closest block body (hereinafter, referred to as "other block bodies). Thereby, the image pickup unit can be assembledmore freely. For example, after the closest block body is attached to the case body, the extending part side of the communicating connection is contained in the other block bodies and the other block bodies are incorporated into the closest block body. As a result, a worker or the like can easily assemble the image pickup unit.

Further, it is possible to form the closest block body so as to pivotally support the case body and to form the slit portion for the communicating connection in at least one of the other block bodies . That is, a member for pivotally supporting the case body and the slit portion are formed in each block body separately. Therefore, the pivotally supporting part is extremely easily formed. It is possible to reduce the manufacturing cost.

In the image pickup unit, the extending part side of the communicating connection may be arranged in an outer block body which is arranged most apart from the case body in the rotational axis direction among the block bodies.

According to the image pickup unit, because the extending part side of the communicating connection is arranged in the outer block body which is arranged most apart from the case body in the rotational axis direction, for example, it is possible to incorporate the outer block body into the case body side after the block bodies except the outer block body are incorporated into the case body side in a state that the axial direction extension part is inserted thereinto and the communicating connection is contained in the predetermined position of the outer block body. Thereby, a worker or the like can easily assemble the image pickup unit.

Further, because the axial direction extension part of the communicating connection extends from the case body part to the outer block body through a relatively long section, a torsion load per unit length, which is applied to the axial direction extension part of the communicating connection by the rotating the case body, becomes small. Therefore, it is possible to improve the durability of the communicating connection exponentially.

In the image pickup unit, the pivotally supporting part may comprise a rotation regulating mechanism for holding the case body in one position selected from a plurality of rotational positions.

According to the image pickup unit, because the case body is held in each rotational position selectively, the case body is not rotated in the image pickup. Therefore, it is possible to carry out the image pickup of the photographic subject clearly without causing a camera shake or the like in the image pickup.

Further, because the case body can be rotated so as to be directed to the photographic subject in accordance with the position of the photographic subject and the like, it is extremely advantageous for practical use.

In the image pickup unit, the rotation regulating mechanism may be provided on a connecting side of the pivotally supporting part, which is connected with the case body.

According to the image pickup unit, because the rotation regulating mechanism is provided on the connecting side of the pivotally supporting part, which is connected with the case body, the interval between the rotation regulating mechanism and the case body and the interval between the rotation regulating mechanism and the connecting portion of the pivotally supporting part becomes short. Thereby, the moment which is applied to each part of the rotation regulating mechanism when the force is applied to the connecting portion of the pivotally supporting part from the case body by rotating the case body, can be reduced. Therefore, the deformation of each part of the rotation regulating mechanism can be prevented. The durability of each part can be improved. It is possible to prevent a slight camera shake for a photographic subject or the like, which is caused by deforming each part in a state that the case body is held by the rotation regulating mechanism.

In the image pickup unit, the rotation regulatingmechanism may comprise:
an engaging plate arranged so that a surface of the engaging plate is perpendicular to the rotational axis;
a plurality of engaging holes formed on the surface of the engaging plate and arranged in a direction of rotating the case body;
a ball body moving on the surface of the engaging plate by rotating the case body and inserted into one hole selected from the plurality of engaging holes; and
a biasing member for biasing the ball body toward the engaging plate.

According to the image pickup unit, when the ball body moves on the surface of the engaging plate and is inserted into one engaging hole, the rotation of the case body is regulated. In this case, when a force is applied to the case body in a circumferential direction, the ball body is escaped from the engaging hole against the biasing force of the biasing member and moves on the engaging plate. Thereafter, when the ball body reaches the adjacent engaging hole, the ball body is inserted into the engaging hole by the biasing force of the biasing member.

Therefore, it is possible that the case body is rotated smoothly by moving the ball body. Because the ball body is inserted into each engaging hole selectively, it is possible to regulate the rotation of the case body reliably.

In the image pickup unit, the engaging plate may be fixed to the case shaft part of the case body; and
the ball body and the biasing member may be provided on the pivotally supporting part side.

Further, in the image pickup unit, the pivotally supporting part may be divided into three block bodies which are arranged in the rotational axis direction in order of an inner block body, a middle block body and an outer block body from the case body side;
the case shaft part may be pivotally supported by the inner block body; and
the ball body and the biasing member may be provided on the middle block body side.

According to the image pickup unit, the engaging plate is rotated with the case body and is selectively engaged with the ball body provided on the pivotally supporting part side. In this case, the ball body and the biasing member are disposed in each block body of the pivotally supporting part. When the pivotally supporting part is incorporated into the case body, the ball body and the biasing member are incorporated into the image pickup unit in a state that the ball body and the biasing member are disposed in each block body. Therefore, it is extremely advantageous for practical use.

The image pickup unit may further comprise a rotation limiting mechanism for rotating the case body within a predetermined angular range.

According to the image pickup unit, the case body is only rotated within the predetermined angular range by the rotation limiting mechanism. Therefore, the case body is not rotated extremely. A force, such as tension, compression or the like, is not applied to the extending part of the communicating connection and the like. It is possible to improve the reliability of the communicating connection more.

In the image pickup unit, the rotation limiting mechanism may comprise:
a projecting portion provided on the case shaft part of the case body; and
a rotation limiting groove into which the projecting portion is inserted, and which extends to the direction of rotating the case body within the predetermined angular range.

According to the image pickup unit, the projecting portion provided in the case shaft part of the case body moves in the rotation limiting groove formed on the pivotally supporting part in accordance with the rotation of the case body. In this case, because the movement of the projecting portion is limited by the both ends of the rotation limiting groove, the rotation of the case body over the predetermined angular range can be reliably limited by the above simple structure.

In the image pickup unit, the communicating connection may comprise a circumferential direction extension part extending to a circumferential direction of the pivotally supporting part in the pivotally supporting part.

According to the image pickup unit, the circumferential direction of the communicating connection is curved in the pivotally supporting part to penetrate through the slit portion along the circumferential direction. That is, when the case body is rotated, the bending deformation is not extremely caused to a portion of the communicating connection, which penetrates through the slit portion. As a result, the bending stress and the like are not extremely applied to the portion of the communicating connection, which penetrates through the slit portion. Therefore, there is no possibility that the extending part of the communicating connection is broken by applying the extreme bending stress and the like to the portion of the communicating connection, which penetrates through the slit portion, repeatedly. It is possible to improve the reliability of the communicating connection more.

In the image pickup unit, among the communicating connection, at least the circumferential direction extension part may be made of a flexible substrate.

According to the image pickup unit, the load, such as torsion or the like, is not applied to each part of the plate-like flexible substrate. In the image pickup unit in which the case body is rotated, the plate-like flexible substrate can be used. It is extremely advantageous for practical use.

In the image pickup unit, among the communicating connection, at least a portion from the axial direction extension part to the extending part may be made of a flexible substrate.

According to the image pickup unit, the load, such as torsion or the like, is not applied to each part of the plate-like flexible substrate. In the image pickup unit in which the case body is rotated, the plate-like flexible substrate can be used. It is extremely advantageous for practical use.

In accordance with the fifth aspect of the present invention, an image pickup unit comprises:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a circumferential direction extension part extending to a circumferential direction of the pivotally supporting part in the pivotally supporting part from an end portion of the axial direction extension part; and an extending part extending to the outside of the pivotally supporting part through the slit portion; and
a connection reinforcing member for reinforcing a joint portion between the axial direction extension part and the circumferential direction extension part is provided on the communicating connection.

According to the image pickup unit, the user or the like of the image pickup unit can pick up an image of a photographic subject by rotating the case body with respect to the pivotally supporting part fixed to, for example, a main body of an electronic apparatus or the like, in accordance with the position of the photographic subject and the like. That is, the user or the like is not required to move the image pickup unit with the electronic apparatus or the like in the image pickup of the photographic subject. As a result, it is extremely advantageous for practical use.

Because the rigidity of the end portion of the axial direction extension part is increased by the connection reinforcing member, the end portion can stand the force applied by the circumferential direction extension part when the circumferential direction extension part is expanded by rotating the case body. The torsion of the end portion of the axial direction extension part can be prevented. In this case, because the direction to which the communicating connection extends is changed by about 90° at the joint portion between the axial direction extension part and the circumferential direction extension part, the stress is concentrated on the joint portion by rotating the case body. However, the joint portion is effectively strengthened against the stress and the like. Further, it is possible to reduce the load to be applied to the communicating connection, and to improve the reliability of the communicating connection exponentially.

In the image pickup unit, the connection reinforcing member maybe provided on the end portion of the axial direction extension part so as to extend to the rotational axis direction.

According to the image pickup unit, because the connection reinforcing member extends to the rotational axis direction from the end portion of the axial direction extension part, the torsional rigidity of the end portion of the axial direction extension part is improved exponentially by the above extension portion of the connection reinforcing member. That is, the rigidity of the joint portion can be increased by the above simple structure.

In the image pickup unit, a receiving portion for receiving the connection reinforcing member may be formed in the pivotally supporting part.

According to the image pickup unit, because the connection reinforcing member extending from the end portion of the axial direction extension part is received by the receiving portion of the pivotally supporting part, the connection reinforcing member is supported by the receiving portion and does not move in a radial direction when the force is applied to the axial direction extension part from the circumferential direction extension part. Therefore, the connection reinforcing member and the axial direction extension part are not moved by rotating the case body. It is possible to prevent the torsion of the end portion of the axial direction extension part adequately.

In the image pickup unit, the connection reinforcing member may comprise a reinforcement extension part which is formed on the communicating connection so as to unite the reinforcement extension part with the axial direction extension part.

According to the image pickup unit, the reinforcement extension part is formed so as to extend the axial direction extension part. That is, the end portion of the axial direction extension part of the communicating connection is formed in an approximate T-shape. Thereby, it is possible to form the connection reinforcing member easily, to unitedly form the axial direction extension part and the connection reinforcing member and to reduce the manufacturing cost.

In the image pickup unit, the connection reinforcing member may comprise a reinforcing portion which is fixed to the end portion side of the axial direction extension part of the communicating connection.

According to the image pickup unit, because the rigidity of the end portion of the axial direction extension part is increased by the reinforcing portion, the torsional rigidity of the joint portion between the axial direction extension part and the circumferential direction extension part is increased. Therefore, the rigidity of the joint portion of the communicating connection can be locally increased effectively.

In the image pickup unit, the communicating connection may be made of a flexible substrate.

According to the image pickup unit, the load, such as torsion or the like, is not applied to each part of the plate-like flexible substrate. In the image pickup unit in which the case body is rotated, the plate-like flexible substrate can be used. It is extremely advantageous for practical use.

In the image pickup unit, the flexible substrate may comprise a wiring portion made of metal, the wiring portion being provided on one surface of the flexible substrate and a strengthening portion made of resin, the strengthening portion being provided on the other surface of the flexible substrate; and
the circumferential direction extension part may be curved so that the one surface of the flexible substrate is an inner surface of the curved circumferential direction extension part.

According to the image pickup unit, because the wiring portion made of metal is an inner surface, it is possible to reduce the load of the curved flexible substrate. It is possible to obtain the reliability of the flexible substrate.

Because the wiring portion of the flexible substrate is an inner surface, the wiring portion can be protected adequately. That is, in case that the outer surface of the flexible substrate is slid on the inner peripheral surface of the pivotally supporting part by rotating the case body, because the strengthening portion is slid, there is no possibility that the transmitting function of the communicating connection is troubled by damaging the wiring portion.

In the image pickup unit, the connection reinforcing member may comprise a curved plate-shaped guide member; and at least an end portion side of the circumferential direction extension part of the flexible substrate may be attached to the guide member.

According to the image pickup unit, because the circumferential direction extension part of the flexible substrate is attached to the guide member, the rigidity of the flexible substrate is increased. In this case, because the end portion side of the circumferential direction extension part of the flexible substrate is attached to the guide member, the deformation, such as bending or the like, is not caused on the end portion side of the circumferential direction extension part by rotating the case body. Further, because the guide member is formed in a curved plate shape, the flexible substrate is curved along the guide member. Therefore, the flexible substrate can be curved stably.

In the image pickup unit, the connection reinforcing member may comprise a guide member formed into a cylindrical shape; and
at least an end portion side of the circumferential direction extension part of the flexible substrate may be attached to an outer peripheral surface of the guide member.

According to the image pickup unit, because the circumferential direction extension part of the flexible substrate is attached to the guide member, the rigidity of the flexible substrate is increased. In this case, because the end portion side of the circumferential direction extension part of the flexible substrate is attached to the guide member, the deformation, such as bending or the like, is not caused on the end portion side of the circumferential direction extension part by rotating the case body. Further, because the guide member is formed in a curved plate shape, the flexible substrate is curved along the guide member. Therefore, the flexible substrate can be curved stably.

In the image pickup unit, the guide member may project into an inner surface side of the pivotally supporting part.

According to the image pickup unit, the guide member is fixed to the pivotally supporting part. The rigidity of the joint portion of the flexible substrate is exponentially increased. Further, because the pivotally supporting part and the guide member and the joint portion of the flexible substrate are moved together, the joint portion of the flexible substrate is followed by the movement of the pivotally supporting part. Therefore, the torsion or the like of the flexible substrate, which is caused by rotating the case body, is suppressed. It is possible to reliably avoid concentrating the stress on the joint portion.

In the image pickup unit, a shape processing treatment may be carried out for the circumferential direction extension part so as to be curved.

According to the image pickup unit, because after the shape processing treatment is carried out for the circumferential direction extension part of the flexible substrate, the flexible substrate is incorporated into the image pickup unit, the flexible substrate is easily attached to the pivotally supporting part. Further, there is no possibility that the internal stress is generated in the flexible substrate and the reliability for the durability of the flexible substrate and the like is decreased like a flexible substrate which is curved by applying a force to a plate-shaped flexible substrate.

In accordance with the sixth aspect of the present invention, an electronic apparatus comprises:
the above-described image pickup unit; and
a processing part which is connected with the communicating connection and to which the image information is transmitted.

According to the electronic apparatus, the user or the like of the electronic apparatus can pick up an image of a photographic subject by rotating the case body with respect to the pivotally supporting part fixed to the main body of the electronic apparatus in accordance with the position of the photographic subject and the like. That is, the user or the like is not required to move the image pickup unit with the main body of the electronic apparatus or the like in the image pickup of the photographic subject. As a result, it is extremely advantageous for practical use.

Then, because the extending part side of the communicating connection is expanded to a longitudinal direction by rotating the case body, a load, such as torsion, is not applied to the axial direction extension part side. Thereby, it is possible to improve the reliability of the communicating connection exponentially.

Because the rigidity of the end portion of the axial direction extension part is increased by the connection reinforcing member, the end portion can stand the force applied by the circumferential direction extension part when the circumferential direction extension part is expanded by rotating the case body. The torsion of the end portion of the axial direction extension part can be prevented. Further, it is possible to improve the reliability of the communicating connection exponentially.

### BRIEF DESCRIPTION OF THE DRAWINGS

The present invention will become more fully understood from the detailed description given hereinbelow and the accompanying drawings which are given by way of illustration only, and thus are not intended as a definition of the limits of the present invention, and wherein;
FIG. 1 is an external perspective view showing the image pickup unit of the first embodiment according to the present invention;
FIG. 2 is a partially exploded perspective view of the image pickup unit;
FIG. 3 is an exploded perspective view of the image pickup unit;
FIG. 4 is an external perspective view of the small image pickup device;
FIG. 5 is a side sectional view of the small image pickup device;
FIG. 6 is an external perspective view of the optical member;
FIG. 7 is a bottom view of the optical member;
FIG. 8 is a partially exploded perspective view of the small image pickup device, which shows a state that the optical member, the elastic member and the intermediate member are incorporated into the small image pickup device;
FIG. 9 is a plan view of the image pickup element;
FIG. 10 is a partially sectional plan view of the electronic apparatus, which shows a state that the image pickup unit is incorporated into the electronic apparatus;
FIG. 11 is a partially sectional side view of the electronic apparatus, which shows a state that the image pickup unit is incorporated into the electronic apparatus;
FIG. 12 is a side sectional view of the circular holding part;
FIG. 13 is an exploded perspective view of the rotational holding part;
FIG. 14 is a view for explaining a state that the bent part of the flexible substrate is held by the contact member in a modified example of the first embodiment according to the present invention;
FIG. 15 is a partially sectional side view of the electronic apparatus, which shows a state that the image pickup unit is incorporated into the electronic apparatus in a modified example of the first embodiment according to the present invention;
FIG. 16 is a side sectional view of the circular holding part in a modified example of the first embodiment according to the present invention;
FIG. 17 is a schematic plan view of the flexible substrate in a modified example of the first embodiment according to the present invention;
FIG. 18 is a schematic plan view of the flexible substrate in a modified example of the first embodiment according to the present invention;
FIG. 19 is an external perspective view showing the image pickup unit of the second embodiment according to the present invention;
FIG. 20 is an exploded perspective view of the image pickup unit;
FIG. 21 is an exploded perspective view of the case body;
FIG. 22 is a rear view of the right block constituting the inner block body;
FIG. 23 is a side view of the right block constituting the inner block body;
FIG. 24 is a rear view of the left block constituting the inner block body;
FIG. 25 is a front view of the middle block body;
FIG. 26 is a sectional view along an A-A line of FIG. 25;
FIG. 27 is a rear view of the middle block body;
FIG. 28 is a front view of the outer block body;
FIG. 29 is a sectional view along a B-B line of FIG. 28;
FIG. 30 is a bottom view of the outer block body;
FIG. 31 is a front view of the engaging plate;
FIG. 32 is a schematic plan view of the electronic apparatus, which shows a state that the image pickup unit is incorporated into the electronic apparatus;
FIG. 33 is a schematic plan view of the flexible substrate in a modified example of the second embodiment according to the present invention;
FIG. 34 is a schematic plan view of the flexible substrate in a modified example of the second embodiment according to the present invention;
FIG. 35 is an external perspective view showing the image pickup unit of the third embodiment according to the present invention;
FIG. 36 is a partially exploded perspective view of the image pickup unit;
FIG. 37 is an exploded perspective view of the image pickup unit;
FIG. 38 is a partially sectional side view of the electronic apparatus, which shows a state that the image pickup unit is incorporated into the electronic apparatus;
FIG. 39 is an exploded perspective view of the flexible substrate;
FIG. 40 is an exploded perspective view of the rotational holding part;
FIG. 41 is an exploded perspective view of the flexible substrate in a modified example of the third embodiment;
FIG. 42 is an external perspective view of the circular holding part in a modified example of the third embodiment;
FIG. 43 is an external perspective view of the circular holding part in the fourth embodiment according to the present invention;
FIG. 44 is an external perspective view of the flexible substrate;
FIG. 45 is an external perspective view of the flexible substrate in a modified example of the fourth embodiment;
FIG. 46 is an external perspective view of the flexible substrate in a modified example of the fourth embodiment; and
FIG. 47 is external perspective view of the circular holding part in a modified example of the fourth embodiment.

### PREFERRED EMBODIMENT OF THE INVENTION

### First Embodiment:

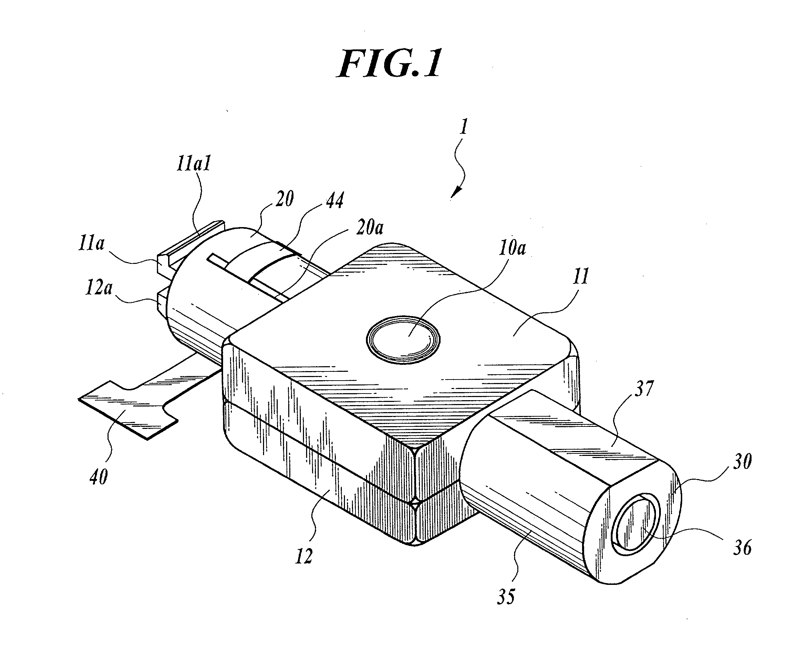

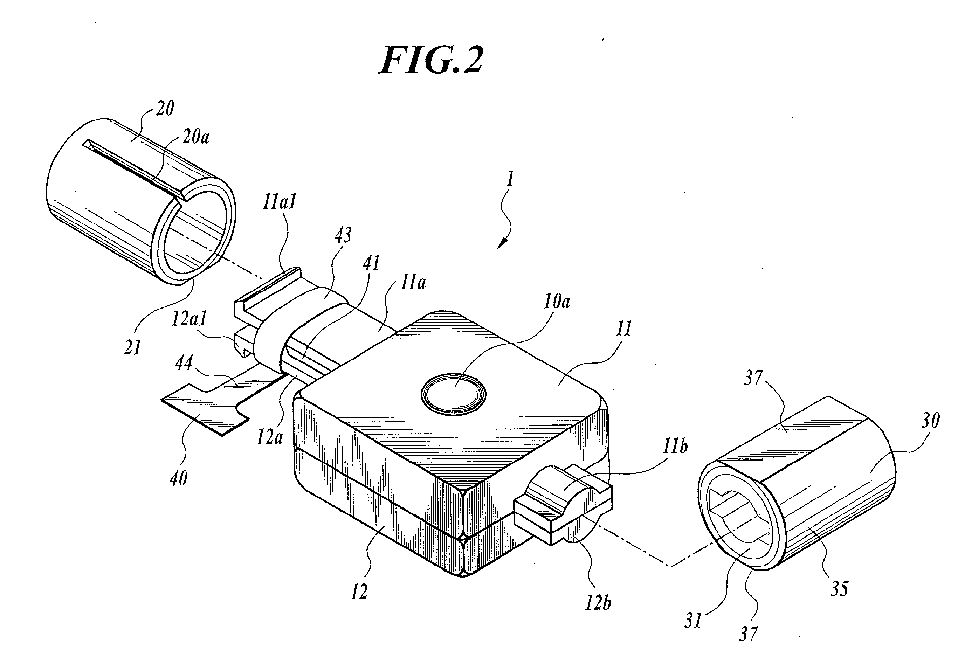

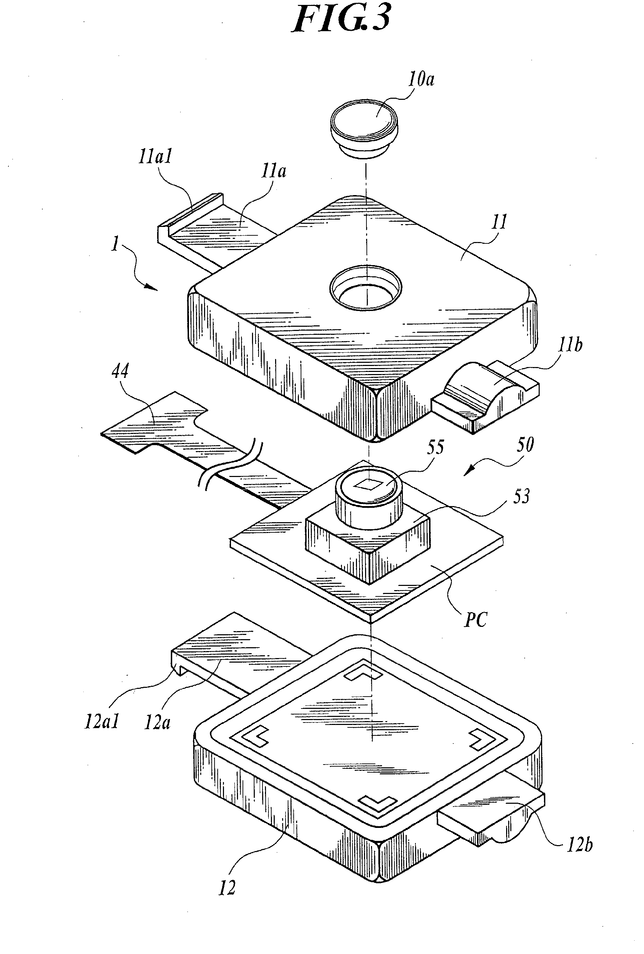

FIGS. 1 to 13 show the first embodiment according to the present invention. FIG. 1 is an external perspective view showing the image pickup unit. FIG. 2 is a partially exploded perspective view of the image pickup unit. FIG. 3 is an exploded perspective view of the image pickup unit.

As shown in FIGS. 1 to 3, the image pickup unit 1 comprises a case body 10 which contains a small image pickup device 50 for picking up an image of a photographic subject therein, and a pair of circular holding part 20 and rotational holding part 30 for pivotally supporting the case body 10, which are provided on right and left sides of the case body 10. As a communicating connection, a flexible substrate 40 connected with the small image pickup device 50, extends from the case body 10 to the outside of the device through the circular holding part 20 used as a pivotally supporting member. The image pickup unit 1 is provided in the electronic apparatus 100, such as a portable telephone or the like. The circular holding part 20 and the rotational holding part 30 are fixed to the main body 101 of the electronic apparatus so as to rotate the case body 10 with respect to the main body 101 of the electronic apparatus. The flexible substrate 40 extending from the image pickup unit 1 is connected with a processing part provided in the electronic apparatus 100.

As shown in FIGS. 2 and 3, the case body 10 comprises an upper case 11 having a translucent panel 10a directed to a photographic subject, and a lower case 12 to which the small image pickup device 50 is fixed. The upper case 11 and the lower case 12 comprises left rotational shaft members 11a and 12a extending toward the circular holding part 20 and right rotational shaft members 11b and 12b extending toward the rotational holding part 30, respectively. On each end portion of the left rotational shaft members 11a and 12a, pawl portions 11a1 and 12a1 for engaging with the left side portion of the circular holding part 20 so as to allow the case body 10 to rotate, are formed. The above-described flexible substrate 40 is arranged between the left rotational shaft members 11a and 12a. Each right rotational shaft member 11b and 12b is fixed to a rotational portion 31 which rotates with respect to a non-rotational portion 35 of the rotational holding part 30. That is, the case body 10 is supported by the circular holding part 20 and the rotational holding part 30 so as to be rotatable. In the first embodiment, the rotational holding part 30 has a positioning function for positioning the case body 10 at a predetermined rotational angle.

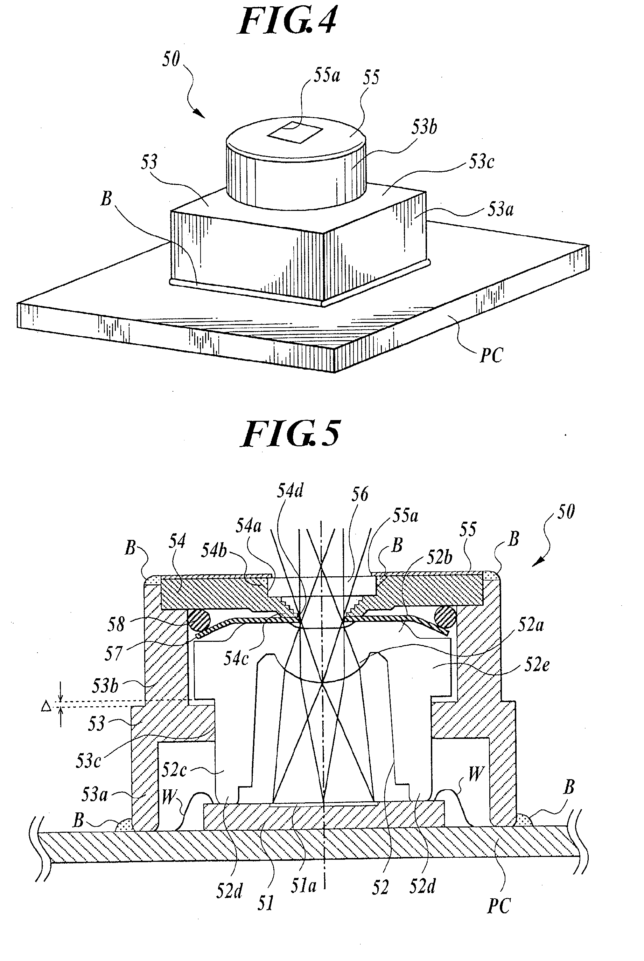

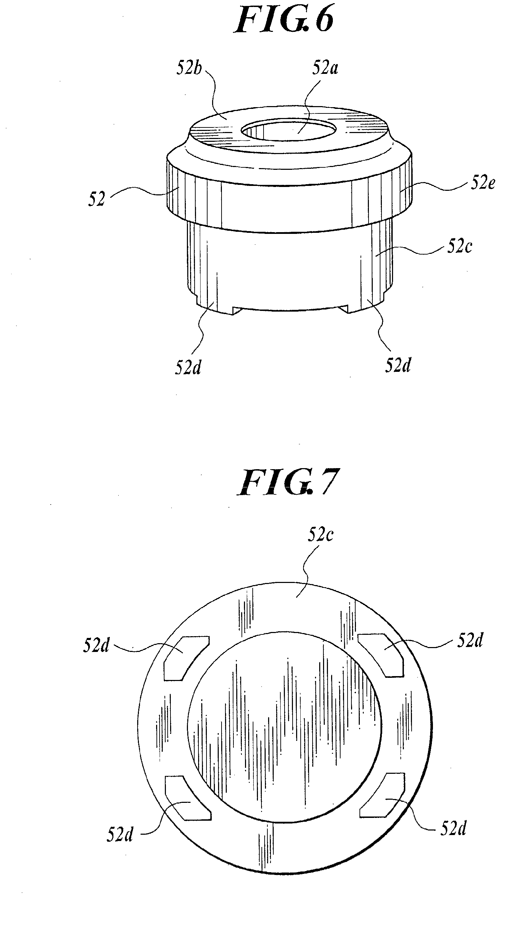

The small image pickup device 50 comprises an image pickup element 51 and an image pickup substrate PC on which the image pickup element 51 is provided, as shown in FIG. 4. The flexible substrate 40 is connected with the image pickup substrate PC. Further, as shown in FIG. 5, the small image pickup device 50 comprises an optical member 52 for forming an image of a photographic subject on the image pickup element 51, a lens frame 53 having a light shielding property and covering the exterior side of the optical member 52, a light shielding plate 54 having a light shielding property and provided on the upper portion of the lens frame 53, a light shielding sheet 55 provided on the upper surface of the light shielding plate 54, and a filter 56 provided on an approximately middle of the light shielding sheet 55.

The optical member 52 is made of transparent plastic material. As shown in FIG. 6, a tubular foot portion 52c, four abutting portions 52d formed on the lower end of the foot portion 52c as a part of the foot portion 52c, a stage portion 52e formed on a peripheral part of the upper end of the foot portion 52c, a plate-shaped upper surface portion 52b for sealing the upper end of the foot portion 52c and a convex lens portion 52a formed on a center of the upper surface portion 52b are unitedly formed into the optical member 52.

On the exterior side of the optical member 52, a lens frame 53 made of a material having a light shielding property is disposed. As shown in FIG. 4, a prismatic lower portion 53a and a cylindrical upper portion 53b are provided on the lens frame 53. The lower end of the lower portion 53a abuts on the image pickup substrate PC and is fixed by bonding agent B. The upper surface of the lower portion 53a is covered with a partition wall 53c on a peripheral side of the optical member 52. The foot portion 52c of the optical member 52 contacts with the inner surface of the partition wall 53c to fit the foot portion 52c to the partition wall 53c.

On the other hand, as shown in FIG. 5, on an upper end of the upper portion 53b of the lens frame 53, the light shielding plate 54 is attached by the bonding agent B. On the upper surface of the light shielding plate 54, the light shielding sheet 55 is attached by the bonding agent B.

In the opening 54a provided on the center of the light shielding plate 54, a filter 56 made of a material having an infrared absorption property is fitted. On the upper edge of the opening 54a of the light shielding plate 54, a taper surface 54b is formed. The light shielding plate 54, the filter 56 and the light shielding sheet 55 are joined by providing the bonding agent B on the taper surface 54b.

Further, the light shielding plate 54 has a diameter shortened portion 54c projecting toward the lower position of the opening 54a and having an inner diameter which is gradually shortened. The portion which is narrowed the most at the lower end of the diameter shortened portion 54c constitutes a first aperture and an opening 54d. The center opening 55a of the light shielding sheet 55 constitutes a second aperture.

As shown in FIG. 5, between the optical member 52 and the light shielding plate 54, a sheet-shaped elastic member 57 made of, for example, a polyester resin, and an intermediate member 58 made of stainless, which has an approximate circular shape (approximate C-shape) having a circular cross section, are arranged.

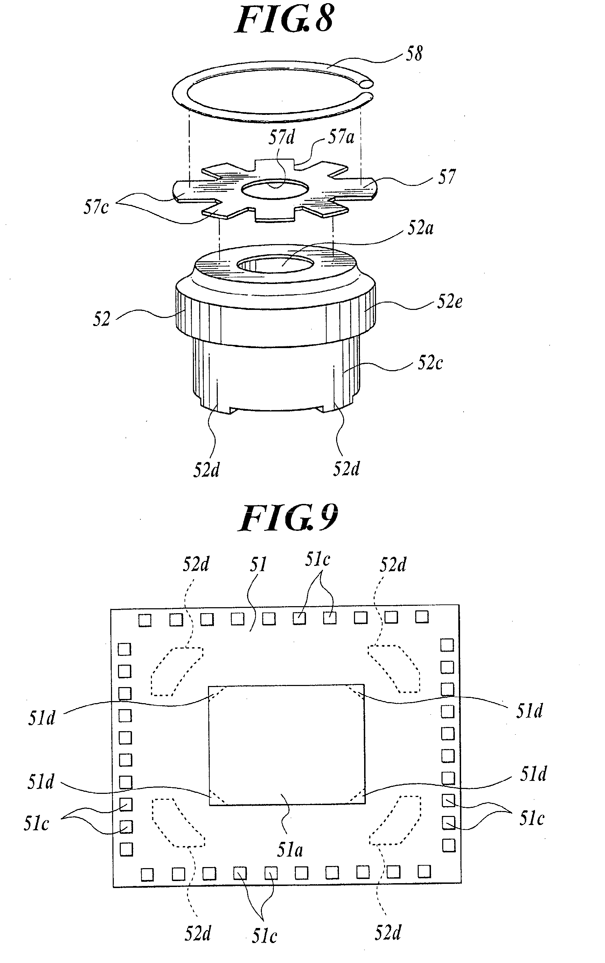

As shown in FIG. 8, the elastic member 57 is a sheet having a gear shape formed by providing notch portions 57a on a peripheral portion at predetermined intervals. An approximate circular plane surface portion 57b which is arranged on the center of the elastic member 57, is provided so as to contact with the upper surface portion 52b of the optical member 52. The intermediate member 58 is provided so as to contact with the upper surface of eight projecting portions 57c formed on the outer edge side of the elastic member 57.

That is, because the light shielding plate 54 is attached to the lens frame 53, the light shielding plate 54 presses the intermediate member 58 to the elastic member 57. Thereby, the elastic member 57 is elastically deformed and presses the optical member 52 down in FIG. 5 to bias the optical member 52 toward the image pickup element 51. Further, because the intermediate member 58 is pressed toward the optical member 52 through the elastic member 57, the projecting portions 57c of the sheet elastic member 57 are elastically deformed and bent. As described above, the intermediate member 58 and the elastic member 57 bias the optical member 52 toward the image pickup element 51 at a predetermined elastic force.

As shown in FIG. 9, the image pickup element 51 is made of a CMOS image sensor. The lower surface of the rectangular thin image pickup element 51 is attached to the upper surface of the image pickup substrate PC. On the center of the upper surface of the image pickup element 51, a photoelectric transfer part 51a in which pixels are arranged in two dimensions, is formed. On a peripheral portion of the image pickup element 51, a peripheral surface 51b is formed. On the inside of the peripheral surface 51b, an image processing circuit is set up. A plurality of pads 51c are arranged near the outer edge portion of the peripheral surface 51b. Pads 51c which are terminals for connection, are connected with the image pickup substrate PC through wires W as shown in FIG. 5. The wires W are connected with a predetermined circuit provided on the image pickup substrate PC. That is, an image of a photographic subject is formed on the photoelectric transfer part 51a of the image pickup element 51 by the lens portion 52a of the optical element 52. The image pickup element 51 transfers an electric signal to an image signal and the like in accordance with an amount of received light and output the image signal and the like through the pads 51c and the wires W.

Further, as shown in FIG. 7, the abutting portions 52d of the optical member 52 projects from the lower edge of the foot portion 52c and constitutes a part of the foot portion 52c. In the first embodiment, as shown in broken lines of FIG. 9, only the abutting portions 52d is disposed so as to abut on the inner side of the pads 51c in the peripheral surface 51b of the image pickup element 51. Therefore, the flatness of the optical member 52 is satisfied only by maintaining the flatness of the lower surface of the abutting portions 52d within a predetermined range. Because the foot portion 52c (abutting portions 52d) are four, the center of gravity of the optical member 52 is positioned in the center thereof. Therefore, the lens portion 52a is positioned and is formed so that an optical axis thereof is perpendicular to a plane surface when the optical member 52 is disposed on the plane surface in a single body.

In this case, for example, the abutting position of the abutting portions 52d is an area which is not used for forming an image, because an active pixel area is slightly smaller than all of the pixel area by removing the corner portions 51d. Thereby, even though the abutting portions 52d abut on the corner portions 51d in the photoelectric transfer part 51a, the image pickup performance of the image pickup element 51 is not influenced.

As shown in FIGS. 1 and 2, the circular holding part 20 used as a pivotally supporting part is formed in an approximate cylindrical shape. Each left rotational shaft member 11a and 12a extending from the case body 10 is inserted into the circular holding part 20. Further, between the light rotational shaft member 11a and 12a, the flexible substrate 40 extending from the case body 10 is arranged. On the peripheral surface of the circular holding part 20, a slit portion 20a for guiding the flexible substrate 40 to the outside of the circular holding part 20 is formed. Further, on the outer peripheral surface of the circular holding part 20, a flat portion 21 having a shape in which a part of the peripheral surface is cut off, is formed.

The flat portion 21 contacts with a receiving portion 102 provided in the main body 101 of the electronic apparatus. Thereby, the circular holding part 20 is engaged with the electronic apparatus 100. The rotation of the circular holding part 20 with respect to the main body 101 of the electronic apparatus is regulated.

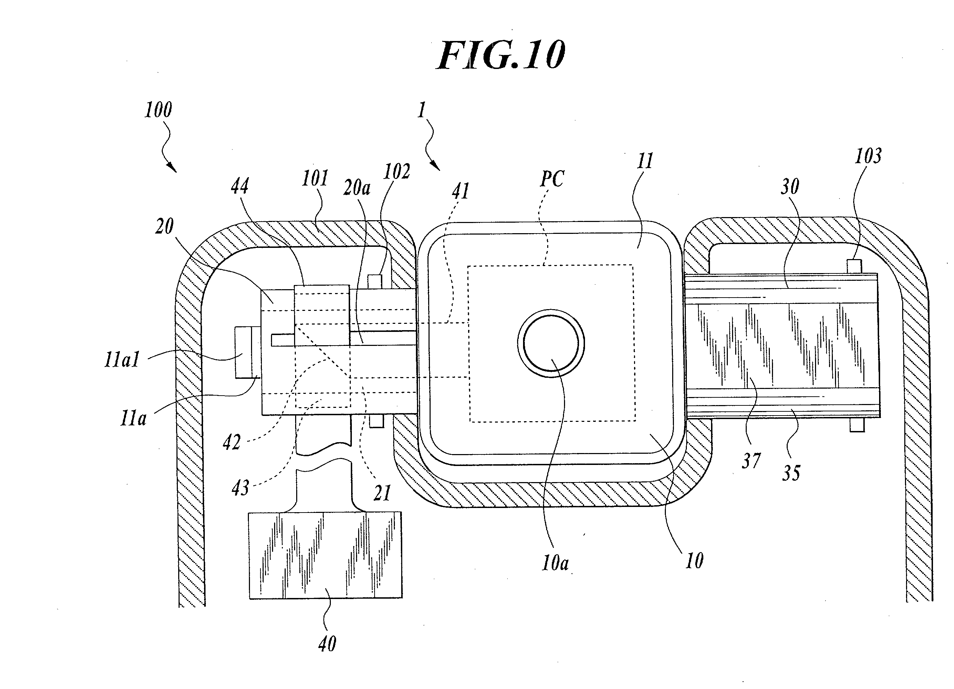

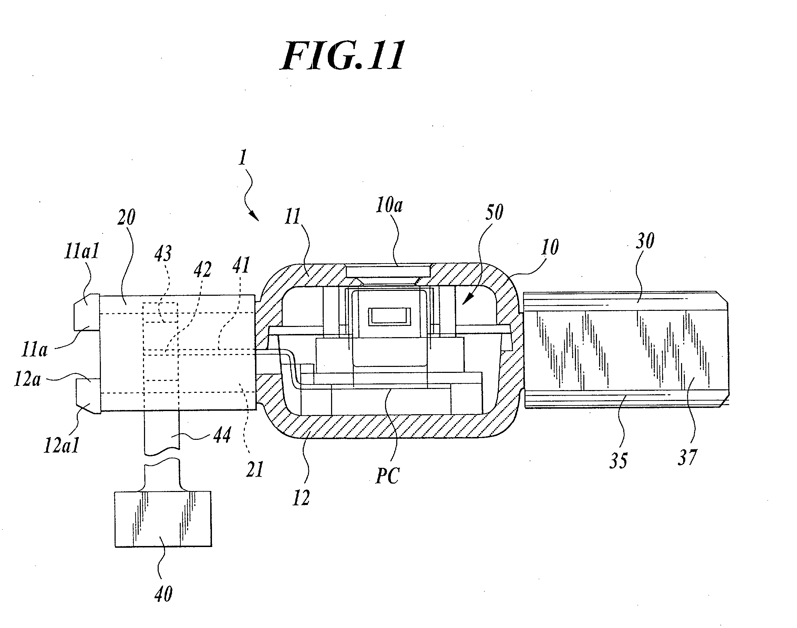

The flexible substrate 40 as a communicating connection transmits the image information obtained by the image pickup element 51, to the outside of the image pickup unit 1. As shown in FIGS. 10 and 11, the flexible substrate 40 comprises an axial direction extension part 41 extending to the rotational axis direction of the case body 10 from the case body 10 to the circular holding part 20, a bent part 42 formed on an end portion of the axial direction extension part 41 to bend the communicating connection 40 in the circular holding part 20 to a direction which is approximately perpendicular to the rotational axis direction, a circumferential direction extension part 43 extending to a circumferential direction of the circular holding part 20 from the end portion of the bent part 42 in the circular holding part 20 and an extending part 44 extending to the outside of the circular holding part 20 through the slit portion 20a. In the first embodiment, by bending the flexible substrate 40 extending to a predetermined direction, the axial direction extension part 41, the bent part 42, the circumferential direction extension part 43 and the extending part 44 are formed. That is, among the communicating connection, at least a portion from the axial direction extension part 41 to the extending part 44 is made of the flexible substrate 40. In this case, the bent part 42 of the flexible substrate 40 is incorporated into the image pickup unit 1 after the flexible substrate 40 is gradually bent at the outside of the image pickup unit 1 so as not to apply a sharp load to the bent portion 42.

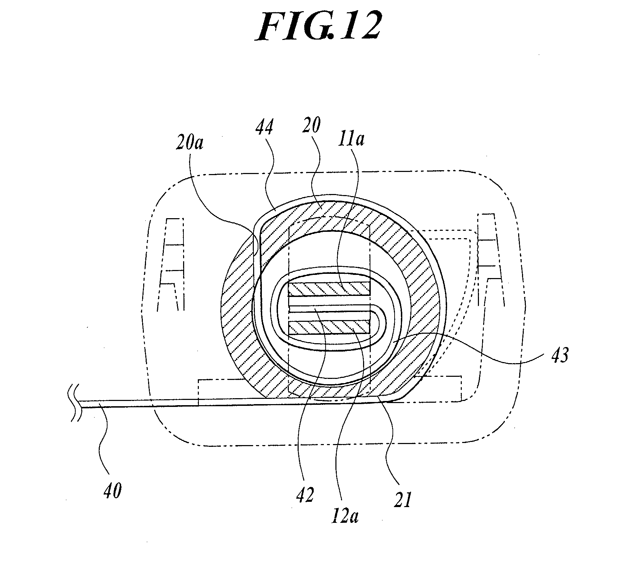

In the first embodiment, as shown in FIG. 11, the axial direction extension part 41 approximately coincides with the rotational axis direction of the case body 10. The bent part 42 is bent so that the bent portion is formed at about 45° with respect to the rotational axis when the bent part 42 is seen from the upper side. The circumferential direction extension part 43 which is continuous to the bent part 42 is curved. As shown in FIG. 12, the bent part 42 side of the circumferential direction extension part 43 extends to the circumferential direction so as to wind each left rotational shaft member 11a and 12a of the case body 10. The extending part 44 side of the circumferential direction extension part 43 extends to the circumferential direction along the inner surface of the circular holding part 20. The extending part 44 which is continuous to the circumferential direction extension part 43 is inserted into the slit portion 20a along the circumferential direction of the circular holding part 20.

The circumferential direction extension part 43 is formed so as to be wound in the circular holding part 20. By rotating the case body 10, the circumferential direction extension part 43 of the flexible substrate 40 is expanded in the circular holding part 20.

The extending part 44 of the flexible substrate 40 is arranged so that a width direction of the extending part 44 coincides with the rotational axis direction of the case body 10. The slit portion 20a of the circular holding part 20, into which the extending part 44 is inserted, is formed so as to extend the slit portion 20a to the rotational axis direction of the case body 10 in accordance with a width of the extending part 44.

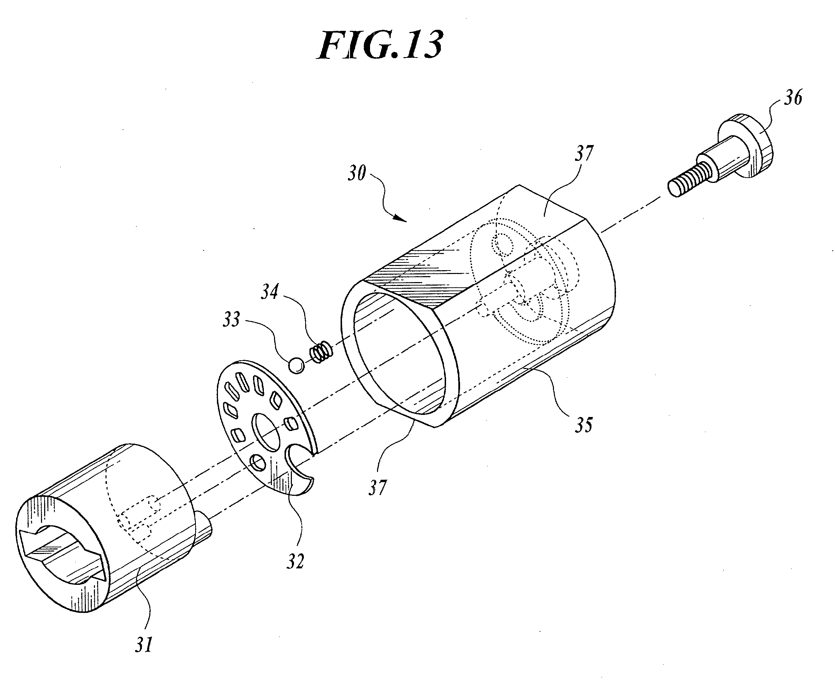

As shown in FIG. 13, the rotational holding part 30 is formed into an approximately cylindrical shape, and comprises a rotational portion 31 which is fitted to the right rotational shaft members 11b and 12b of the case body 10, an engaging plate 32 for rotating with the rotational portion 31 unitedly, an engaging member 33 for engaging with each hole portion 32a of the engaging plate 32 selectively, an elastic body 34 for biasing the engaging member 33 toward the engaging plate 32, a non-rotational portion 35 fixed to the main body 101 of the electronic apparatus, and a stepped screw 36 inserted into the engaging plate 32 and the non-rotational portion 35 and screwing the rotational portion 31. The rotational holding part 30 support the case body 10 so as to be rotatable.

The rotational portion 31 is formed in an approximate cylindrical shape and is engaged with the engaging plate 32 for covering a right opening of the rotational portion 31. The rotational portion 31 is screwed by the stepped screw 36 inserted into the engaging plate 32 and the non-rotational portion 35. Thereby, the rotational portion 31, the engaging plate 32 and the stepped screw 36 unitedly rotates with respect to the non-rotational portion 35.

In the engaging plate 32, a plurality of engaging holes are arranged in circumferential direction (in a direction of rotating the case body 10). The engaging member 33 is selectively engaged with each hole 32a. The rotational angle of the rotational portion 31 with respect to the non-rotational portion 35 is selectively determined. That is, the rotational angle of the case body 10 which rotates with the rotational portion 31 unitedly is also selectively determined.

The engaging member 33 is formed in an approximately ball shape, and is biased to the engaging plate 32 by the elastic body 34. That is, when the rotational force is applied to the case body 10 (rotational portion 31) in a state that the engaging member 33 is engaged with any one of the holes 32a, the engaging member 33 is escaped from the hole 32a against the biasing force of the elastic body 34, and moves on the engaging plate 32.

The elastic body 34 is a helical spring having a spiral shape is engaged in a predetermined position of the non-rotational portion 35. That is, the engaging member 33 and the elastic body 34 are always fixed to the non-rotational portion 35.

The non-rotational portion 35 almost constitutes the outer shape of the rotational holding portion 30 and is formed in an approximately cylindrical shape. On the outer peripheral surface of the non-rotational portion 35, two flat portions 37 are formed. Each flat portion 37 contacts with the receiving portion 103 provided in the main body 101 of the electronic apparatus. Thereby, the rotational holding part 30 is engaged with the electronic apparatus 100. The rotation of the rotational holding part 30 with respect to the main body 101 of the electronic apparatus is regulated.

In the image pickup unit 1 having the above-described structure, the user or the like of the electronic apparatus 100 can pick up an image of a photographic subject by rotating the case body 10 with respect to the circular holding part 20 fixed to the electronic apparatus 100 in accordance with the position of the photographic subject and the like.

Because the extending part 44 side of the flexible substrate 40 is expanded to a longitudinal direction by rotating the case body 10, a load, such as torsion, is not applied to the axial direction extension part 41 side. Because the extending part 44 of the flexible substrate 40 is arranged so that a width direction of the extending part 44 coincides with the rotational axis direction, a load, such as torsion, is not applied to the extending part 44 side. The flexible substrate 40 is bent in a thickness direction in which the flexural rigidity is relatively small.

Because the circumferential direction extension part 43 is wound in the circular holding part 20 and the flexible substrate 40 is expanded in the circular holding part 20 by rotating the case body 10, the flexible substrate 40 is not expanded out of the circular holding part 20. Therefore, the position of the connecting end portion between the flexible substrate 40 and the processing part of the electronic apparatus 100 is not changed.

As described above, according to the image pickup unit 1 of the first embodiment and the electronic apparatus 100 having the above image pickup unit 1, because it is possible to pick up an image of a photographic subject by rotating the case body 10, a user or the like is not required to move the image pickup unit 1 with the main body 101 of the electronic apparatus in the image pickup of the photographic subject. As a result, it is extremely advantageous for practical use.

According to the image pickup unit 1 of the first embodiment and the electronic apparatus 100 having the above image pickup unit 1, because the extending part 44 side of the flexible substrate 40 is expanded by the case body 10 and a load, such as torsion, is not applied to the axial direction extension part 41 side, the load to be applied to the flexible substrate 40 is reduced. It is possible to improve the reliability of the flexible substrate 40 exponentially.

According to the image pickup unit 1 of the first embodiment and the electronic apparatus 100 having the above image pickup unit 1, because the flexible substrate 40 is arranged so that a width direction of the extending part 44 coincides with the rotational axis direction, the torsion force is not applied to the extending part 44. Thereby, it is possible to improve the reliability of the flexible substrate 40 exponentially. In particular, according to the first embodiment, a load, such as torsion or the like, is not applied to each part of the plate-like flexible substrate 40. In the image pickup unit in which the case body is rotated, the plate-like flexible substrate can be used. It is extremely advantageous for practical use. Further, because the extending part 44 of the flexible substrate 40 is bent in the thickness direction in which the flexural rigidity is relatively small, the flexible substrate 40 is allowed to be bent when the case body 10 is rotated. It is possible to rotate the case body 10 smoothly.

According to the image pickup unit 1 of the first embodiment and the electronic apparatus 100 having the above image pickup unit 1, because the flexible substrate 40 is expanded in the circular holding part 20 by rotating the case body 10, the position of the end portion of the extending part 44 of the flexible substrate 40 is not changed. It is not necessary that a processing part of the electronic apparatus 100, which is connected with the end portion of the extending part 44, has a structure which copes with the expansion of the flexible substrate 40. As a result, it is extremely advantageous when the electronic apparatus 100 having the image pickup unit 1 is designed.

According to the image pickup unit 1 of the first embodiment and the electronic apparatus 100 having the above image pickup unit 1, because the flat portion 21 is formed on the outer peripheral surface of the circular holding part 20, by using the flat portion 21 of the circular holding part 20, the image pickup unit 1 can be easily fixed to or engaged with the main body 101 of electronic apparatus. That is, when the image pickup unit 1 is incorporated into the electronic apparatus 100, the position of the approximately cylindrical circular holding part 20 with respect to the main body 101 of the electronic apparatus can be precisely determined by using the flat portion 21 as a reference. Further, in the circular holding part 20 formed into an approximately cylindrical shape, by providing the receiving portion 102 for contacting the flat portion 21 with the main body 101 of the electronic apparatus, the rotation of the circular holding part 20 can be regulated easily and reliably. Further, in the rotational portion 30, by forming the flat portion 37 on the outer peripheral surface of the rotational portion 30, the function and effect which is the same as the ones obtained by forming the flat portion 21 on the outer peripheral surface of the circular holding part 20, can be obtained.

According to the image pickup unit 1 of the first embodiment and the electronic apparatus 100 having the above image pickup unit 1, by only positioning the image pickup substrate PC and the lens frame 53, for example, with an optical sensor or the like, which is provided on an automatic assembling machine, so that the center of the circular opening portion of the partition wall 53c coincides with the center of the photoelectric transfer part 51a of the image pickup element 51, it is possible to precisely position the lens portion 52a with respect to the photoelectric part 51a of the image pickup element 51 in a direction which is perpendicular to the optical axis.

According to the image pickup unit 1 of the first embodiment and the electronic apparatus 100 having the above image pickup unit 1, because the light shielding plate 54, the light shielding sheet 55 and the filter 56 constitute the cover member, and the image pickup substrate PC, the lens frame 53 and the cover member are closely joined, it is possible to effectively exclude dusts and moisture from the small image pickup device 50.

According to the image pickup unit 1 of the first embodiment and the electronic apparatus 100 having the above image pickup unit 1, when a force is applied from the light shielding plate 54 toward the image pickup element 51, the force is not directly transmitted to the image pickup element 51 by elastically deforming the elastic member 57 to actuate a cushioning function for absorbing the force. As a result, the damage of the image pickup element 51 is prevented.

According to the image pickup unit 1 of the first embodiment and the electronic apparatus 100 having the above image pickup unit 1, because a different elastic force can be generated from one elastic member 57 by using the intermediate member 58 having a different shape or a different thickness, it is possible to easily adjust an elastic force to a desired strength.

According to the image pickup unit 1 of the first embodiment and the electronic apparatus 100 having the above image pickup unit 1, because one selected from the elastic member 57 and the intermediate member 58, has an approximately circular cross section taken along a direction perpendicular to the optical axis of the lens portion, the pressing load generated by the light shielding plate 54 is applied to the optical member 52 uniformly. As a result, the optical member 52 can be stably biased.

According to the image pickup unit 1 of the first embodiment and the electronic apparatus 100 having the above image pickup unit 1, by providing the notch portions 57a on the outer peripheral portion of the elastic member 57 to form the elastic member 57 in a gear shape, it is possible to relieve the strain generated by elastically deforming and bending the elastic member 57. That is, for example, in case that the elastic member 57 is formed in a doughnut shape which has no notch portions on the outer peripheral portion thereof, when the outer peripheral portion thereof is pressed by the approximately circular intermediate member 58, there is some possibility that the strain is generated because of the difference in the variation of flexibility between the outer peripheral portion and the inner peripheral portion. According to the first embodiment, there is no possibility that the strain is caused to the elastic member 57. As a result, the elastic member 57 has no disadvantage for the function of the elastic means.

According to the image pickup unit 1 of the first embodiment and the electronic apparatus 100 having the above image pickup unit 1, even though there is space between the inner peripheral surface of the lens frame 53 and the outer peripheral surface of the optical member 52, when the foot portion 52c abuts on the peripheral surface 51b of the image pickup element 51, the optical axis is perpendicular to the photoelectric transfer part 51a of the image pickup element 51. Therefore, the image having less strain can be obtained. In this case, on the rear side (lower surface side in case of FIG. 1) of the peripheral surface 51b, a circuit of the image pickup element 51 (including a signal processing circuit), which is not shown in the drawings, is provided. However, the process carried out by the circuit is not influenced by contacting the abutting portions 52d with the peripheral surface 51b.

According to the image pickup unit 1 of the first embodiment and the electronic apparatus 100 having the above image pickup unit 1, because the space Δ is provided between the lower surface of the stage portion 52e of the optical member 52 and the partition wall 53c of the lower portion 53a of the lens frame 53 in a state that the abutting portions 52d abut on the peripheral surface 51b of the image pickup element 51, the length L between the lens portion 52a and the photoelectric transfer part 51a of the image pickup element 51 (that is, the positioning in the optical axis direction) is precisely set in accordance with the length of the foot portion 52c. In this case, according to the first embodiment, four abutting portions 52d are provided. However, one to three abutting portions may be provided. If the interference with the pads 51c can be avoided, a ring-shaped abutting portion formed along the circular foot portion 52c of the optical member 52 may be used.

According to the image pickup unit 1 of the first embodiment and the electronic apparatus 100 having the above image pickup unit 1, because the optical member 52 is made of plastic material, a shift of the focal point, which is caused by the variation of the refractive index of the lens portion due to the change in the temperature, can be reduced. That is, as the temperature increases, the refractive index of the plastic lens is decreased. As a result, the focal point is shifted apart from the lens. However, because the foot portion 52c is extended by increase the temperature, it is possible to reduce the shift of the focal point. Because the optical member 52 of the first embodiment is made of plastic material having a relatively light gravity, the plastic lens is lighter than a glass lens having the same volume as the plastic lens. Further, because the plastic lens has an excellent shock absorbing property, the damage of the image pickup element 51 can be suppressed as less as possible even though the shock is applied to the small image pickup device 50, for example when the electronic apparatus 100 is accidentally dropped.

According to the image pickup unit 1 of the first embodiment and the electronic apparatus 100 having the above image pickup unit 1, because the optical member 52 is attached not on the image pickup substrate PC but on the peripheral surface 51b of the image pickup element 51, it is not required to control the focal point of the lens portion 52a on the incorporation of the optical member 52 and the like by controlling the precision of the size of the foot portion 52c (including the abutting portions 52d) of the optical member 52, that is, by controlling the precision of the above length L. In order not to require the control of the focal point, it is necessary that a shift length between the photoelectric transfer part 51a of the image pickup element 51 and the image point of the lens portion 52a of the optical member 52, is suppressed within about ±F x 2P (F: F number of the lens portion, P: pixel pitch of the image pickup element) expressed by the reduced length in air.

According to the image pickup unit 1 of the first embodiment and the electronic apparatus 100 having the above image pickup unit 1, by contacting the abuttingportions 52d of the foot portion 52c of the optical member 52 with the peripheral surface 51b of the image pickup element 51, it is possible to determine the position of the lens portion 52a and that of the photoelectric transfer part 51a of the image pickup element 51 in the optical axis direction. Further, because the lens frame 53 is set on the image pickup substrate PC as a reference of the position of the photoelectric transfer part 51a of the image pickup element 51, it is possible to determine the position of the lens portion 52a and that of the photoelectric transfer part 51a of the image pickup element 51 in the optical axis direction. The high precision of the positioning thereof can be achieved at a low cost.

In case that the pads 51c and the wires W for connecting the image pickup element 51 with the image pickup substrate PC are formed on the peripheral surface 51b of the image pickup element 51, when the abutting portions 52d of the foot portion 52c are formed so as to abut on the photoelectric transfer element 51 side of the peripheral surface 51b apart from the pads 51c it is possible to keep the image pickup element in a compact structure and to obtain a large abutting area of the abutting portions 52d. Thereby, it is possible to stabilize the optical member 52 and to suppress the surface pressure applied to the abutting surface. As a result, it is possible to protect the image pickup element 51, to prevent the interference with the pads 51c and the wires W and to achieve the high precise positioning. Further, because the lens frame 53 is bonded to the image pickup substrate PC by a bonding agent in addition to two boding part to keep the small image pickup device 50 in a sealed state so that a foreign object does not enter the small image pickup device 50, it is possible to eliminate a bad effect on the photoelectric transfer part 51a of the image pickup element 51, which is caused by the foreign object. In this case, it is preferable to use the bonding agent having a moisture-proof property. Thereby, it is possible to prevent the deterioration of each surface of the image pickup element 51 and the pads 51c, which is caused by the moisture entering the small image pickup device 50.

According to the image pickup unit 1 of the first embodiment and the electronic apparatus 100 having the above image pickup unit 1, because the elastic member 57 for pressing the stage portion 52e of the optical member 52 at a predetermined elastic force in the optical axis is provided, the foot portion 52c (abutting portions 52d) is pressed to the peripheral surface 51b of the image pickup element 51 by using an elastic force of the elastic member 57 against the lens frame 53 at a suitable abutting force along the optical axis direction. Therefore, it is possible to easily determine the position of the optical member 52 and that of the image pickup element 51 in the optical axis direction and to bias the optical member 52 toward the image pickup element 51 by a stable elastic force even though the deformation, such as warping, is caused to a part with time. Thereby, it is possible to suppress the backlash of the optical member 52 when the electronic apparatus is vibrated. An undue stress is not applied to the peripheral surface 51b of the image pickup element 51, on the inside of which the circuit is provided, when a shock is caused. When a large force, such as a shock force, is applied to the lens frame 53 in the optical axis direction, the force is transmitted to the image pickup substrate PC. However, the force is not directly transmitted to the image pickup element 51. It is possible to protect the image pickup element 51. As an example of the elastic member 57, it is thought that urethane, sponge and the like are used. However, it is preferable that a sheet-like member made of resin or metal, which generates a stable elastic force for a long time, is used.

According to the image pickup unit 1 of the first embodiment and the electronic apparatus 100 having the above image pickup unit 1, because the cover member formed by the light shielding plate 54, the light shielding sheet 55 and the filter 56, is disposed on a photographic subject side as compared with the lens portion 52a, the lens portion 52a is not bared. As a result, it is possible to protect the lens portion 52a and to prevent the adhesion of a foreign object to the lens surface. Further, because the filter 56 is made of a material having an infrared absorption property, it is not necessary that another infrared cutting filter is provided. The number of parts can be decreased. The optical member 52 itself may be made of a material having an infrared absorption property without providing an infrared cutting property for the filter 56. A film having an infrared cutting property may be coated on the surface of the lens portion 52a.

According to the image pickup unit 1 of the first embodiment and the electronic apparatus 100 having the above image pickup unit 1, when the optical member 52 and the like are incorporated, the light shielding plate 54 can be attached to the lens frame 53 after the optical member 52 is inserted into the lens frame 53 from a photographic subject side in a state that the light shielding plate 54 is detached from the lens frame 53. Thereby, the attachment of the optical member 52 is improved and it is possible to easily carry out, for example, the automatic attachment. In this case, it is possible to easily attach the optical member 52 by forming a hole for escaping air on the lower portion 53a of the lens frame 53, even though there is space between the lens frame 53 and the optical member 52. by sealing the hole for escaping air with packing material after the optical member 52 is attached, it is possible to prevent the entrance of a foreign object from the outside and to prevent the deterioration of each surface of the image pickup element 51 and the pads 51c, which is caused by moisture, and the like. Further, in this case, it is preferable to use the packingmaterial having a light shielding property so as to prevent a light leakage. After the lens frame 53 is bonded to the image pickup substrate PC, the optical member 52 may be inserted. After the optical member 52 is attached to the lens frame 53, the unit thereof may be bonded to the image pickup substrate PC. Thereby, the it is possible to assemble the image pickup unit freely. In the latter case for assembling the image pickup unit, the partition wall 53c of the lens frame 53 has a function for preventing the optical member 52 from falling off.

According to the image pickup unit 1 of the first embodiment and the electronic apparatus 100 having the above image pickup unit 1, the second aperture (opening 55a) for regulating the marginal light flux is arranged on a photographic subject side of the first aperture (opening 54d) for defining the F number of the lens portion 52a to reduce the undue incident light. Therefore, a ghost or a flare which is caused by disposing the foot portion 52c of the optical member 52 near the photoelectric transfer part 51a of the image pickup element 51 and reflecting the light flux which does not contribute the image forming, on the foot portion 52c and by the entrance of the reflected light flux to the photoelectric transfer part 51a, can be effectively prevented. Because one field angle is different from another in a short side direction, a long side direction and a diagonal direction of the photoelectric transfer part 51a of the image pickup element 51, it is possible to obtain the above-described effect more by forming the second aperture which is the opening 55a, in a rectangle shape. In the first embodiment, the opening 54d of the light shielding plate 54 has the above function. However, an aperture may be formed by coating or applying a film having a light shielding property on a photographic subject side of the filter 56 except the necessary opening portion. From the same reason, it is preferable to carry out an internal surface anti reflection treatment for at least a part of the foot portion 52c. The inner surface refection preventing process is carried out, for example, by forming a surface on which fine irregularities are provided to scatter a light flux which does not contribute the image forming or by applying a reflection preventing coating or a coating having a low reflecting property.

In the first embodiment, the image information is transmitted by the flexible substrate 40. However, the image information may be transmitted by another communicating connection, for example, a transmission cable or the like.

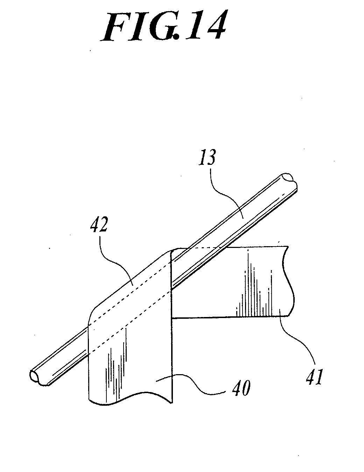

In the first embodiment, the bent part 42 of the flexible substrate 40 is bent so as to be independent of the image pickup unit 1. However, as shown in FIG. 14, a contact member 13 for contacting with the bent part 42 may be provided in one of the right rotational shaft members 11a and 12a and the bent part 42 of the flexible substrate 40 may be formed by contacting the flexible substrate 40 with the contact member 13 to bend the flexible substrate 40. In this case, it is possible to bend the flexible substrate 40 by using the contact member 13 and to form the bent part 42 adequately. Further, because the shape of the bent part 42 can be kept by the contact member 13, there is no possibility that the stress to be caused by deforming the bent part 42 in accordance with the rotation of the case body 10, is concentrated. Thereby, it is possible to improve the reliability of the flexible substrate 40 exponentially.

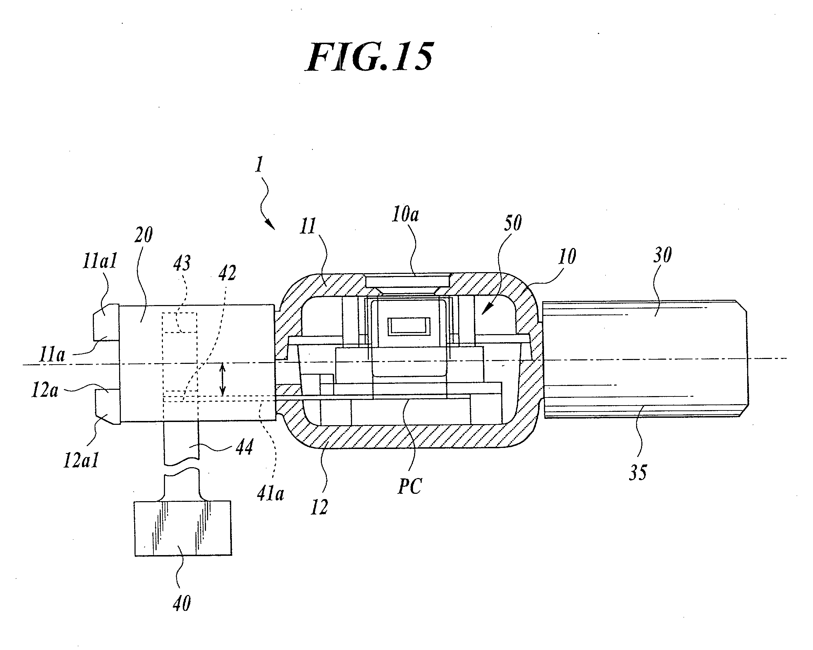

In the first embodiment, the axial direction extension part 41 approximately coincides with the rotational axis direction of the case body 10. However, as shown in FIG. 15, the axial direction extension part may be formed apart from the rotational axis of the case body 10 toward a radial direction of the circular holding part 20. In this case, the bent part 42 is bent toward the rotational axis. The circumferential direction extension part 43 is formed so as to be gently curved by using the space apart from the rotational axis.

That is, because the circumferential direction extension part 43 of the flexible substrate 40 is gently curved, a portion of the circumferential direction extending part 43, which is shapely curved, is not formed. The stress and the like are not concentrated on the specific portion of the circumferential direction extension part 43 by rotating the case body 10. Therefore, it is possible to improve the reliability of the flexible connection more.

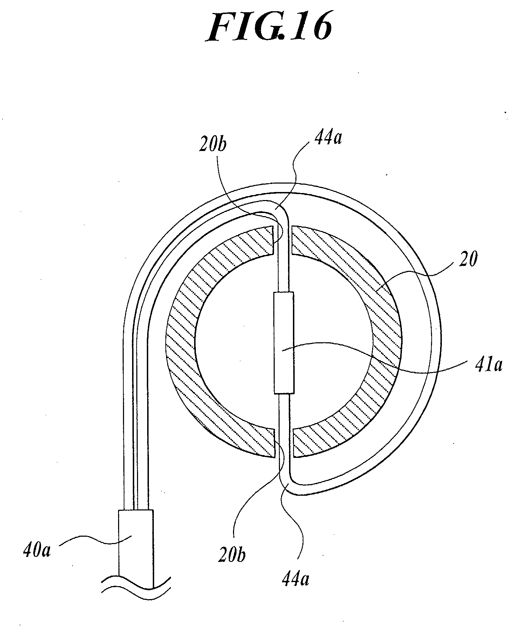

In the first embodiment, one slit portion 20a is formed on the circular holding part 20. One extending part 44 of the flexible substrate 40 is inserted into the slit portion 20a. However, as shown in FIG. 16, the circular holding part 20 may comprise a plurality of slit portions 20b and the flexible substrate 40 may comprise a plurality of extending parts which are formed so as to correspond to each slit portion 20b. In FIG. 16, the circular holding part 20 comprises two slit portions 20b formed symmetrically with respect to the center axis of the circular holding part 20. The flexible substrate 40a comprises two extending parts 44a inserted into each slit portion 20b.

In this case, the image information and the like obtained by the image pickup unit 51 are transmitted to the outside of the circular holding part 20 through a plurality of extending parts 44a of the flexible substrate 40a. That is, by a plurality of extending parts 44a, quantities of image information and the like can be transmitted. Further, because the flexible substrate 40a comprises a plurality of extending parts 44a, a width of one extending part 44a can be narrowed. The load to be applied to the extending parts 44a extending in accordance with the rotation of the case body 10, can be dispersed.

In the first embodiment, the flexible substrate 40 is expanded in the circular holding part 20. However, the circumferential direction extension part 43 may be fixed to an inner surface of the circular holding part 20 by a double-sided tape or the like. The flexible substrate 40 may be expanded to the outside of the circular holding part 20 by rotating the case body 10.

In this case, the flexible substrate 40 is not expanded in the circular holding part 20. The circumferential direction extension part 43 and the like of the flexible substrate 40, which are curved in the circular holding part 20, are not deformed by rotating the case body 10. Therefore, the load is not applied to the curved portion and the like of the flexible substrate 40. It is possible to improve the reliability of the flexible substrate 40 more.

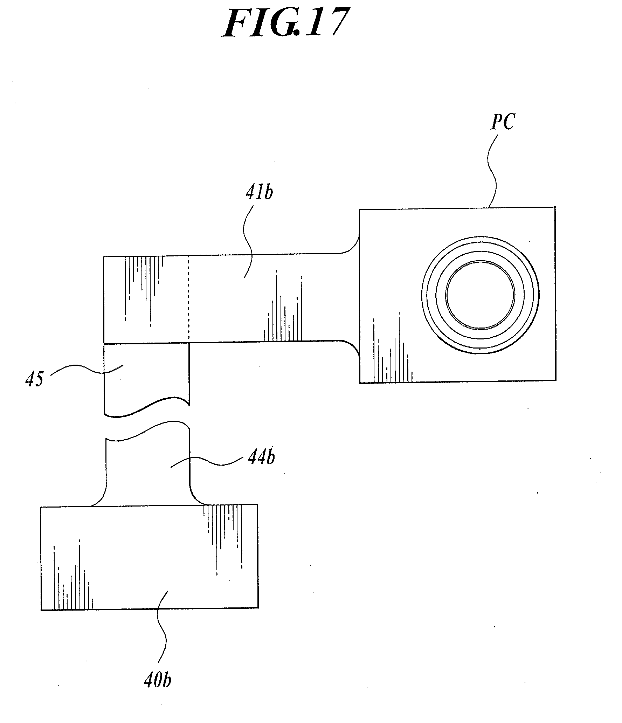

In the first embodiment, the communicating connection is formed by bending one flexible substrate. For example, as shown in FIG. 17, the communicating connection may be formed by connecting a plurality of flexible substrates. The flexible substrate 40b used as a communicating connection, comprises an axial direction extension part 41b which is the same as one shown in the first embodiment, a perpendicular direction extension part 45 connected with an end portion of the axial direction extension part 41b and extending to a direction which is approximately perpendicular to the rotational axis direction, and an extending part 44b which is the same as one shown in the first embodiment. The flexible substrate 40b is constituted of the different substrates which are separated into the axial direction extension part 41b side and the extending part 44b side. The end portion of the axial direction extension part 41b are jointed with the end portion of the perpendicular direction extension part 45.

In this case, the user or the like of the electronic apparatus 100 can pick up an image of a photographic subject by rotating the case body 10 with respect to the circular holding part 20 fixed to, for example, a main body of an electronic apparatus or the like, in accordance with the position of the photographic subject and the like. Further, because the extending part 44b side of the flexible substrate 40b is expanded to a longitudinal direction by rotating the case body 10, a load, such as torsion, is not applied to the axial direction extension part 41b side. Further, in this case, the flexible substrate 40b can be easily formed by connecting the axial direction extension part 41b with the perpendicular direction extension part 45. Therefore, it is possible to reduce the manufacturing cost.

Further, in addition to the flexible substrate 40 which is formed by joining a plurality of flexible substrate parts, the flexible substrate in which the axial direction extension part and the perpendicular direction extension part are unitedly formed, may be used. That is, the flexible substrate may be formed in an approximate L-shape. In this case, because the axial direction extension part and the perpendicular direction extension part are unitedly formed, the strength of the joint portion between the axial direction extension part and the perpendicular direction extension part can be improved exponentially. In this case, because the direction to which the communicating connection extends is changed by about 90° at the joint portion, the stress and the like is concentrated on the joint portion by rotating the case body. However, the joint portion is effectively strengthened against the stress and the like. Further, it is possible to improve the reliability of the communicating connection. Because the axial direction extension part and the perpendicular direction extension part of the communicating connection are unitedly formed, it is possible to reduce the manufacturing cost.

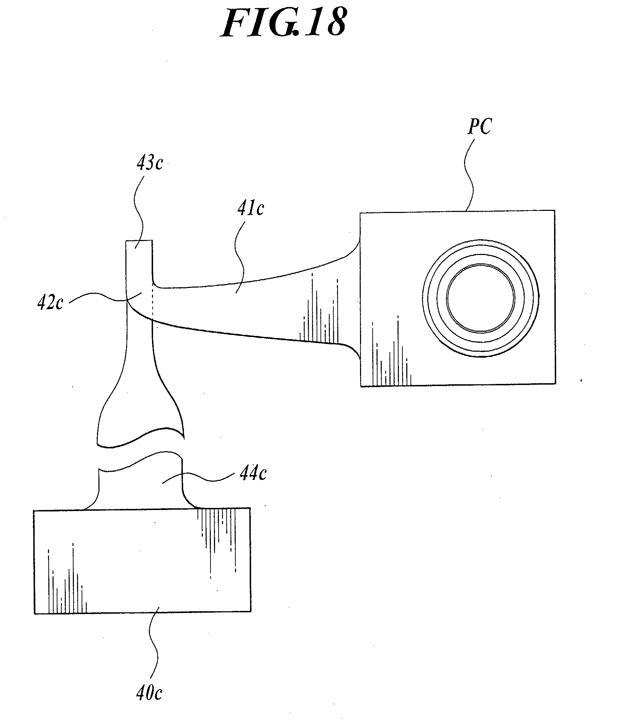

Further, in the first embodiment, the width of the flexible substrate 40 is not changed in a whole length. However, for example, as shown in FIG. 18, the width of the communicating connection 40c may be changed. In the communicating connection 40c, the width of the axial direction extension part 41c is gradually narrow toward the bent part 42c. The width of the circumferential direction extension part 43c made of a flexible substrate is gradually wide toward the extending part 44c. That is, among the communicating connection 40c, at least the circumferential direction extension part 43c is made of a flexible substrate. In this case, the load, such as torsion or the like, is not applied to each part (circumferential direction extension part 43c and the like) of the plate-like flexible substrate. In the image pickup unit in which the case body 10 is rotated, the plate-like flexible substrate can be used. It is extremely advantageous for practical use.

In the first embodiment, the flat portions 21 and 37 are provided on the circular holding part 20 and the rotational holding part 30, respectively. However, the flat portion may be provided on one of the circular holding part 20 and the rotational holding part 30 or neither of them. Further, in the first embodiment, the circular holding part 20 and the rotational holding part 30 are fixed to the main body 101 of the electronic apparatus. However, either of them is fixed to the main body.

In the first embodiment, the image pickup element 51 is connected with the image pickup substrate PC by wires W. For example, the wires and the like may be provided in the image pickup element 51 to fetch a signal from the rear surface of the image pickup element 51 (the opposite surface to the photoelectric transfer part 51a) or the side surface of the image pickup element 51. In this structure, it is possible to obtain the peripheral surface of the image pickup element 51 widely and to arrange the wires easily.

In the first embodiment, the elastic body 57 is formed in a gear shape having the notch portions 57a. Even though, for example, the notch portions 57a of the elastic member 57 do not have the same shape and the projecting portions 57c of the elastic member 57 are not formed at the same intervals, it is possible to relieve the strain generated by bending the elastic member 57 from the notch portions 57a and to prevent the elastic member 57 from being deformed.

In the first embodiment, the image pickup element 51 is a bare chip. However, by covering the upper surface or the lower surface of the image pickup element 51 with a protect member, such as a glass, a film or the like, the image pickup element may have a stronger structure. The image pickup substrate may be not only a rigid substrate but also a flexible substrate.

When the sheet-like elastic member 57 having a gear shape, which is used in the first embodiment, is made of a material having a light shielding property, the center opening 57d of the elastic member 57 can function as an aperture. Because the elastic member 57 having the center opening 57d is provided on an incident plane side of the lens portion 52a, the light flux can be incident to the photoelectric transfer part 51a of the image pickup element 51 approximately perpendicularly. That is, the light flux is incident in an approximately telecentric state. Thereby, a high definition image can be obtained. Further, by forming the lens portion 52a in a positive lens in which a surface having a large curvature is directed to the image side, the interval between the aperture (center opening 57d) and the principal point of the lens portion 52a becomes longer. The above optical system comes closer to a telecentric state.

In the first embodiment, as an electronic apparatus 100 having an image pickup unit 1, a portable telephone is exemplified. However, the electronic apparatus may be a personal computer, a PDA, an AV equipment, a television, an electric home appliance, and other electronic apparatuses.

As long as the circular holding part 20 of the first embodiment is formed so as to be able to arrange the communicating connection, it is not necessary that the circular holding part 20 is formed in a cylindrical shape. The shape of the case body 10 and the like can be modified within a scope of the present invention. Other concrete detail structures may be also modified.

As described above, according to the image pickup unit of the present invention, because the case body of the image pickup unit can be rotated in accordance with the position of a photographic subject, the user or the like is not required to move the case body with the electronic apparatus or the like including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

By bending one connection part of the communicating connection, which extends to a predetermined direction, the axial direction extension part, the bent part and the extending part can be easily formed. Therefore, it is possible to reduce the manufacturing cost.

According to the image pickup unit of the present invention, because the case body of the image pickup unit can be rotated in accordance with the position of a photographic subject, the user or the like is not required to move the case body with the electronic apparatus or the like including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

The communicating connection is easily formed by connecting the axial direction extension part with the perpendicular direction extension part. Therefore, it is possible to reduce the manufacturing cost.

According to the electronic apparatus of the present invention, because the case body of the image pickup unit can be rotated in accordance with the position of a photographic subject, the user or the like is not required to move the case body with the electronic apparatus including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

### Second Embodiment:

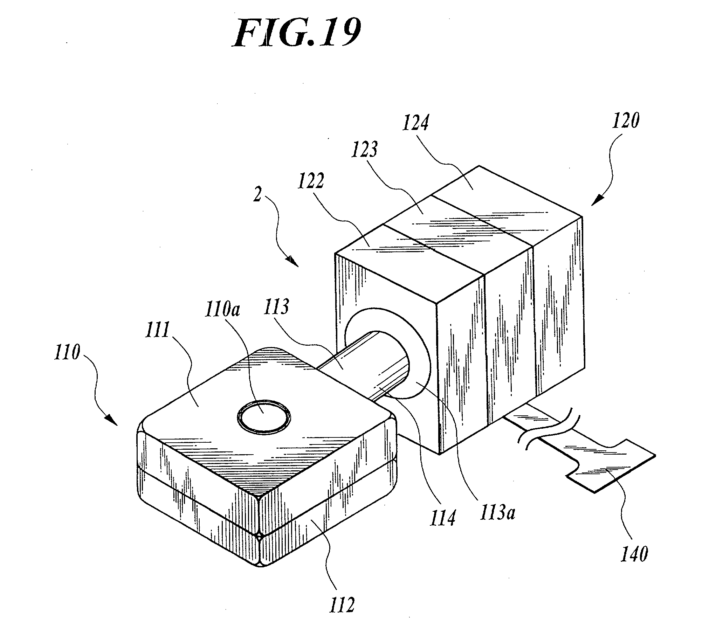

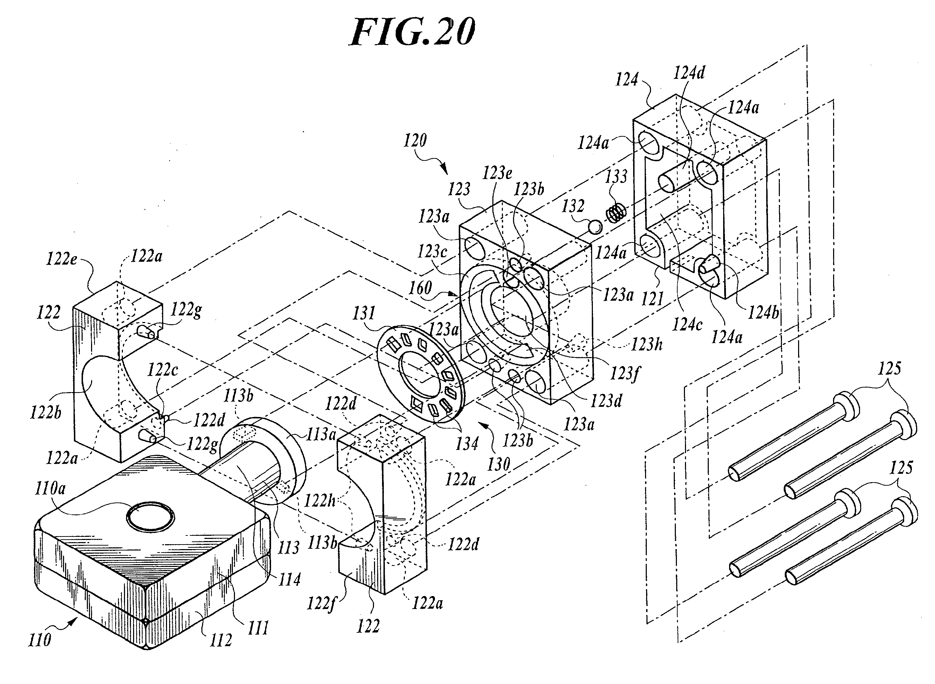

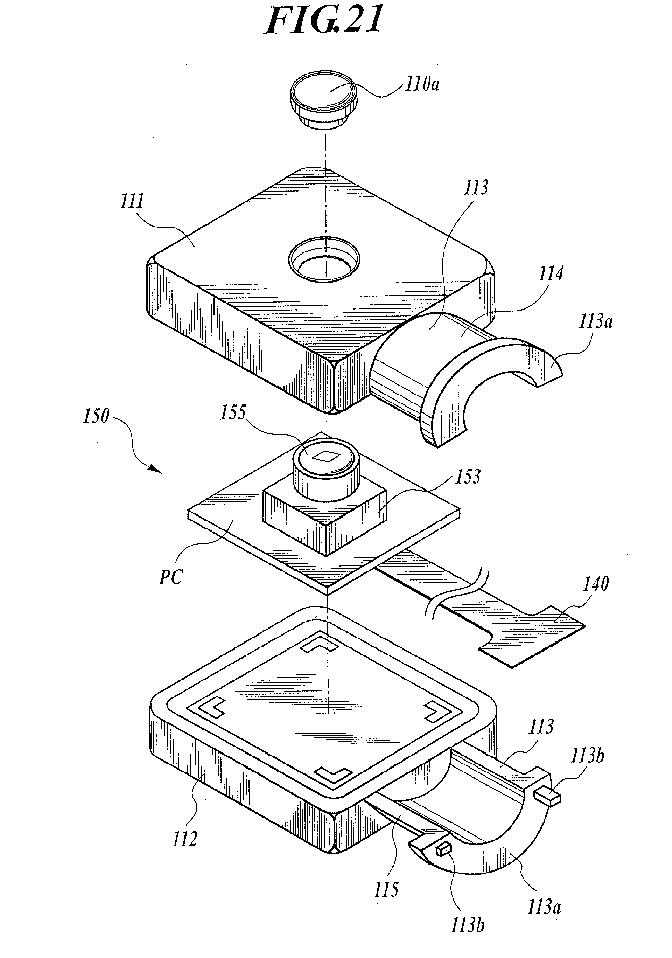

FIGS. 19 to 32 show the second embodiment according to the present invention. FIG. 19 is an external perspective view showing the image pickup unit. FIG. 20 is a partially exploded perspective view of the image pickup unit. FIG. 21 is a partially exploded perspective view of the image pickup unit.

As shown in FIGS. 19 and 20, the image pickup unit 2 comprises a case body 110 which contains a small image pickup device 150 for picking up an image of a photographic subject therein, and a rectangular holding part 120 for pivotally supporting the case body 110. As a communicating connection, a flexible substrate 140 connected with the small image pickup device 150, extends from the case body 110 to the outside of the unit through the rectangular holding part 120 used as a pivotally supporting member. The image pickup unit 2 is provided in the electronic apparatus 200, such as a portable telephone or the like. The rectangular holding part 120 is fixed to the main body 201 of the electronic apparatus so as to rotate the case body 110 with respect to the main body 201 of the electronic apparatus. The flexible substrate 140 extending from the image pickup unit 2 is connected with a processing part provided in the electronic apparatus 200.

As shown in FIG. 21, the case body 110 comprises an upper case 111 having a translucent panel 110a directed to a photographic subject, and a lower case 112 to which the small image pickup device 150 is fixed. The case body 110 comprises an approximately cylindrical case shaft part 113 extending to the rectangular holding part 120. In the second embodiment, the case shaft part 113 is formed into an approximately cylindrical shape and is constituted of the rotational shaft members 114 and 115 and the like, which are formed in a semi-cylindrical shape on the upper case 111 and the lower case 112, respectively. That is, by incorporating the upper case 111 and the lower 112 into one body, the case shaft part 113 is formed into one cylindrical member. In the inner space of the case shaft part 113, the above-described flexible substrate 140 extending to the outside of the case body 110, is arranged. The case body 110 has a cantilever structure that only the case body 110 is supported by the rectangular holding part 120. In the second embodiment, a rotation regulating part 130 for holding the case body 110 at a plurality of rotational angles selectively, is provided in the rectangular holding part 120.

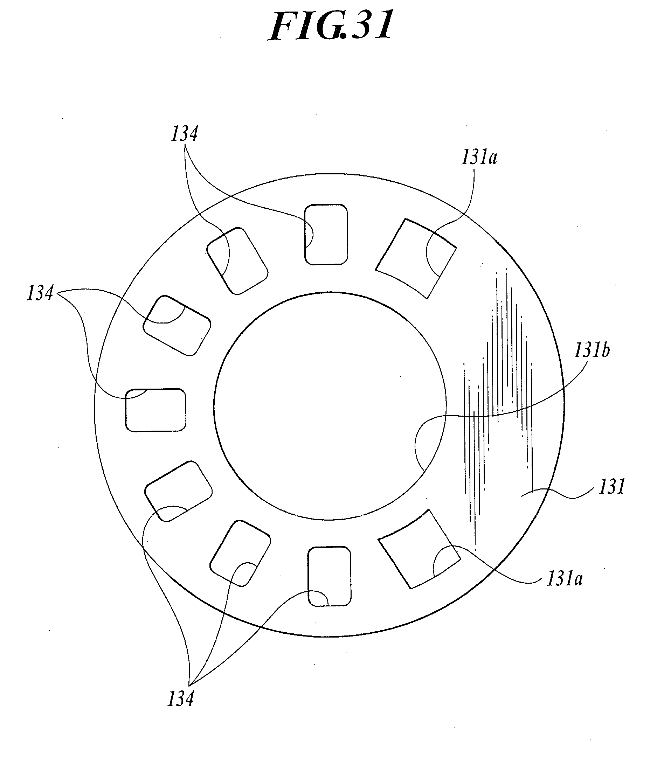

The structure of the rotation regulating part 130 will be explained. As shown in FIG. 20, the rotation regulating part 130 used as a rotation regulating mechanism comprises an engaging plate 131 arranged so that a surface of the engaging plate is perpendicular to the rotational axis of the case body 110, a ball 132 moving on one surface of the engaging plate 131, and a coil spring 133 for biasing the ball 132 toward the engaging plate 131. As shown in FIG. 31, a plurality of engaging holes 134 are formed on the engaging plate 131 so as to be arranged in a circumferential direction. The ball 132 used as a ball body is inserted into each engaging hole 134 selectively. At the center of the engaging plate 131, a connection hole 131b into which the axial direction extension part 141 of the flexible substrate 140 is inserted is formed. The coil spring 133 used as a biasing member extends to the rotational axis direction and is disposed in the rectangular holding part 120 in a state that the coil spring 133 is compressed in the rotational axis direction. The coil spring 133 always biases the ball 132 toward the engaging plate 131. The arrangement state that the engaging plate 131, the ball 132, the coil spring 133 and the like are arranged in the rectangular holding part 120 will be explained below.

As shown in FIG. 20, on the end portion of the case shaft part 113, a flange portion 113a extending toward the outside in a radial direction is formed. The rear surface of the flange portion 113a is formed into a flat surface. On the rear surface, two projecting portions 113b projecting backward are formed. Each projecting portion 113b is inserted into the inserting hole 131a formed in the engaging plate 131. Thereby, the engaging plate is fixed to the case body 110 side. In the second embodiment, one projecting portion 113b is formed so as to project longer than the other projecting portion 113b.

As shown in FIGS. 19 and 20, the rectangular holding part 120 used as a pivotally supporting part is formed in an approximately hollow quadratic prism and pivotally supports the case shaft part 113 extending from the case body 110. In the inner space of the case shaft part 113, the flexible substrate 140 extending from the case body 110 is arranged. On the peripheral surface of the rectangular holding part 120, the slit portion 121 for guiding the flexible substrate 140 to the outside of the rectangular holding part 120 is formed. Hereinafter, assuming that the case body 110 side is a front side and the rectangular holding part 120 side is a rear side, that is, the rotational axis direction of the case body 110 is a forward and backward direction, the structure of the image pickup unit 2 will be explained.

As shown in FIG. 20, the rectangular holding part 120 is divided into a plurality of block bodies arranged in the rotational axis direction of the case body 110. In the second embodiment, the rectangular holding part 120 is divided into three block bodies which are arranged in the rotational axis direction in order of an inner block body 122, a middle block body 123 and an outer block body 124 from the case body side. In each block body 122, 123 and 124, the screw holes 122a, 123a and 124a extending to the rotational axis direction are formed respectively. As shown in FIG. 19, by the screw holes 122a, 123a and 124a and the screws 125 inserted into the screw holes, the block bodies 122, 123 and 124 are unitedly fixed. In the second embodiment, each screw hole 122a, 123a and 124a is formed around four corner portions of each block body 122, 123 and 124. By the four screws 125, the block bodies 122, 123 and 124 are fixed.

As shown in FIGS. 19 and 20, the inner block body 122 is formed into a rectangular shape and pivotally supports the case shaft part 113 of the case body 110. On the center portion of the inner block body 122, a pivotally supporting hole 122b for contacting with the outer peripheral surface of the flange portion 113a of the case shaft part 113, is formed so as to penetrate the inner block body 122 in the rotational axis direction. On the middle block body 123 side, the diameter of the pivotally supporting hole 122b is expanded. The expanded portion of the pivotally supporting hole 122b is a front side engaging plate attaching hole 122c for attaching the engaging plate 131. On the rear surface of the inner block body 122, the fitted portions 122d extending toward the middle block body 123 are formed. In the second embodiment, three fitted portions 122d are formed and are fitted into the fitting holes 123b formed on the middle block body 123.

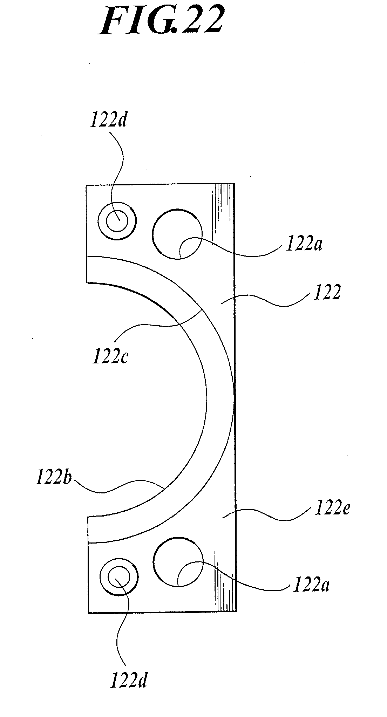

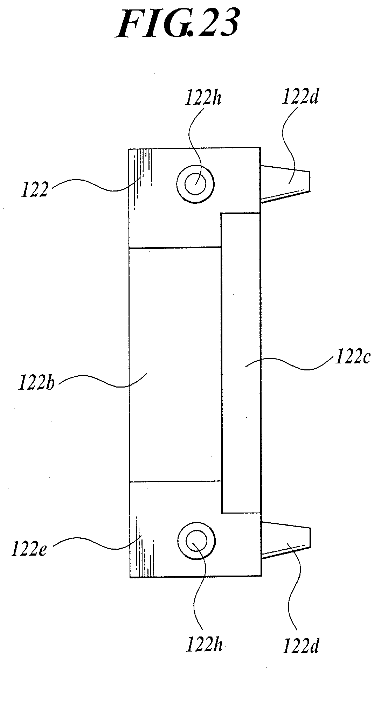

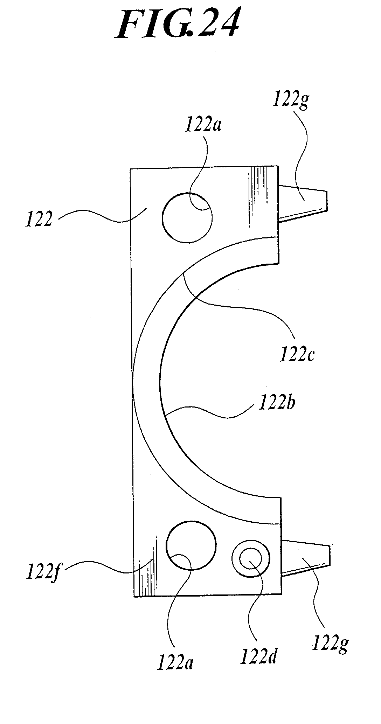

The inner block body 122 is divided into a right block 122e (see FIGS. 22 and 23) and a left block 122f (see FIG. 24). As shown in FIG. 24, on one of the blocks 122e and 122f, the fitted portions 122g extending toward the other block are formed. Further, as shown in FIG. 23, on the other block of the blocks 122e and 122f, the fitting holes 122h for fitting the fitted portions 122g are formed. That is, as shown in FIG. 20, by fitting the block 122e into the block 122f from the outside of the flange portion 113a of the case shaft part 113 of the case body 110, the inner block body 122 is incorporated into the case body 110.

As shown in FIGS. 19 and 20, the middle block body 123 is formed into a rectangular shape and comprises an inserting hole 123f for inserting the flexible substrate 140, which penetrates the middle block body 123 in the rotational axis direction. On the front side of the middle block body 123, the fitting holes 123b for fitting the fitted portions 122d formed on the inner block body 122, are formed.

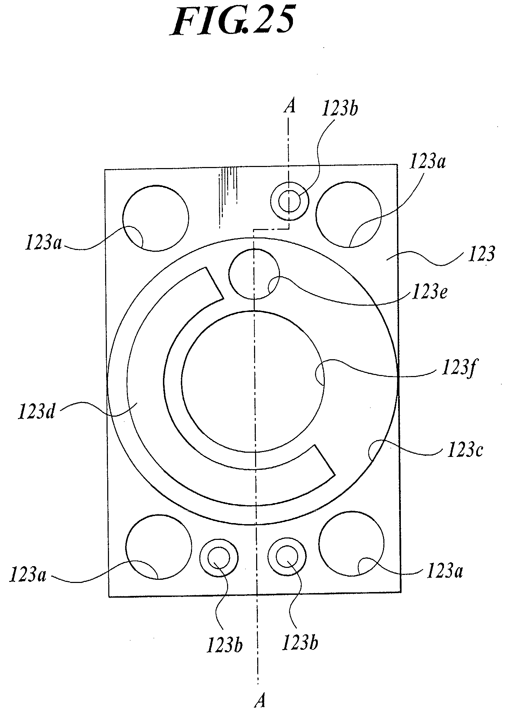

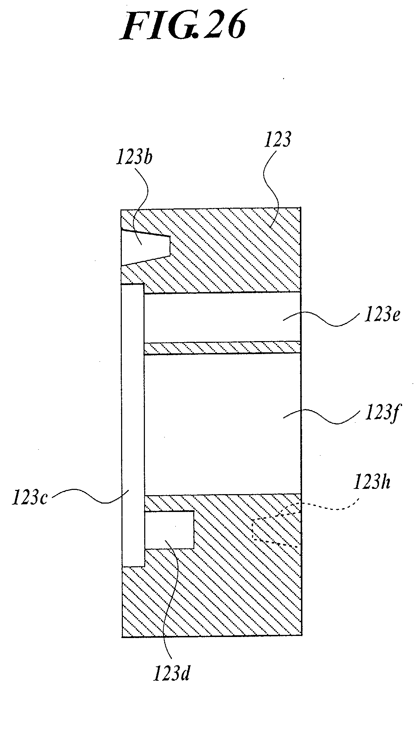

As shown in FIGS. 25 and 26, on the front surface of the middle block body 123, a rear side engaging plate attaching hole 123c for attaching the engaging plate 131 is formed at the center of the middle block body 123. That is, the engaging plate 131 is received by the front side engaging plate attaching hole 122c and the rear side engaging plate attaching hole 123c in a state that the inner block body 122 is connected with the middle block body 123.

On the middle block body 123, the rotation limiting groove 123d for inserting one projecting portion 113b formed on the flange portion 113a of the case body 110 is formed. The rotation limiting groove 123d extends to the circumferential direction within the predetermined angular range. The inserted projecting portion 113b is movable in the rotation limiting groove 123d within the predetermined angular range. That is, one projecting portion 113b and the rotation limiting groove 123d constitute the rotation limiting part 160 as a rotation limiting mechanism. The case body 110 is rotatable with respect to the rectangular holding part 120 within the predetermined angular range.

As shown in FIGS. 25 to 27, in the middle block body 123, a rotation regulating hole 123e for receiving the ball 132 and the coil spring 133 is formed. The rotation regulating hole 123e is formed so as to penetrate the middle block body 123 in the rotational axis direction. The ball 132 is disposed on the inner block body 122 side of the rotation regulating hole 123e. The coil spring 133 is disposed on the outer block body 124 side of the rotation regulating hole 123e. In this case, the coil spring 133 is pressed by the projecting portion 124d of the outer block body 124. In a state that the coil spring 133 is compressed, the coil spring 133 is contained in the middle block body 123. Thereby, the ball 132 is always biased toward the engaging plate 131.

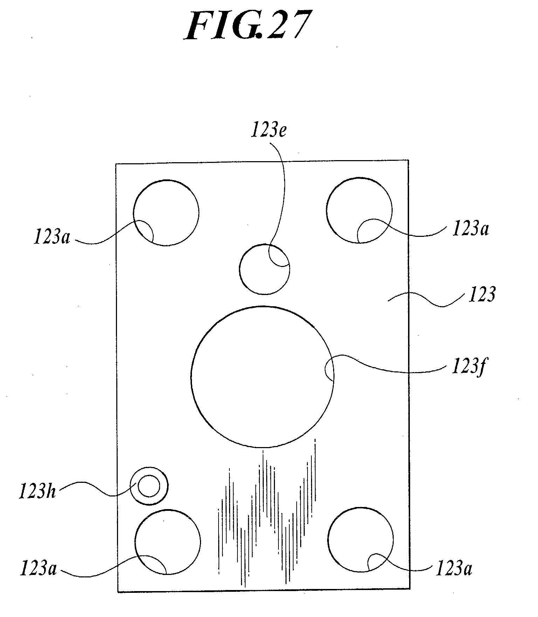

As shown in FIGS. 26 and 27, on the rear surface of the middle block body 123, the fitting hole 123h for fitting the fitted portion 124b of the outer block body 124 is formed. Thereby, the position of the middle block body 123 and that of the outer block body 123 can be adequately determined.

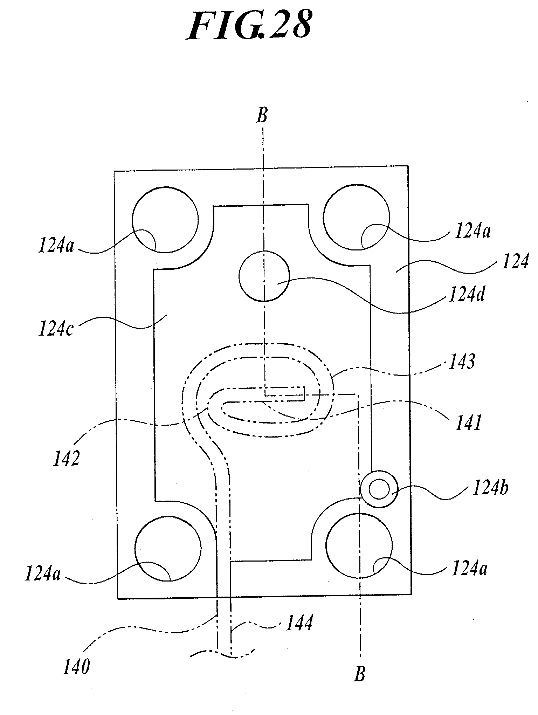

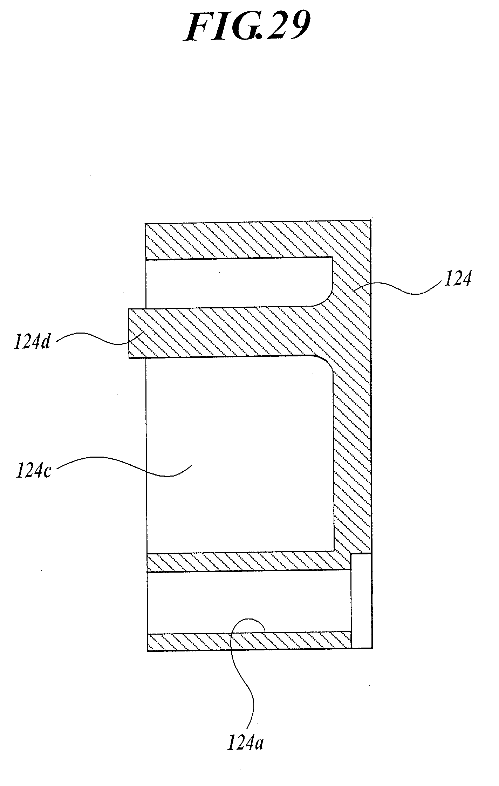

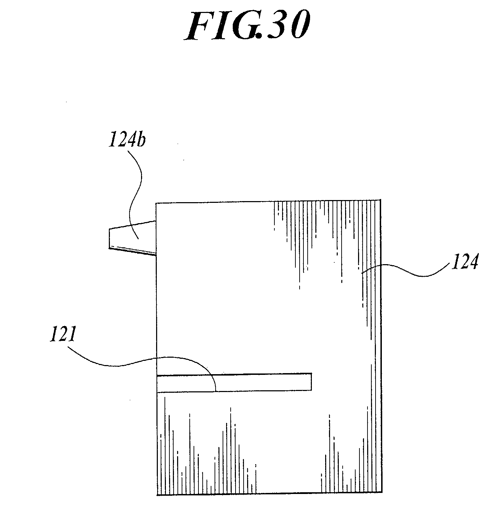

As shown in FIGS. 28 and 30, on the front surface of the outer block body 124, the fitted portion 124b extending toward the middle block body 123 is formed. As shown in FIGS. 28 and 29, a cavity is formed in the outer block body 124. The cavity constitutes a substrate containing part 124c for containing the bent part 142, the circumferential direction extension part 143, the extending part 144 and the like of the flexible substrate 140. In the substrate containing part 124c, an approximately cylindrical projecting portion 124d extending to the rotational axis direction is formed. The projecting portion 124d is formed so as to project into the middle block body 123 from the front surface of the outer block body 124. The projecting part of the projecting portion 124d is received by the rotation regulating hole 123e of the middle block body 123 and supports one edge of the coil spring 133.

On the outer block body 124, the slit portion 121 into which the flexible substrate 140 is inserted so as to penetrate the outer block body 124 is formed. As shown in FIG. 30, the slit portion 121 is formed on one side surface of the outer block body 124 so as to extend to the rotational axis direction from the edge formed on the middle block body 123 side.

The explanation of the image pickup device 150 is approximately the same as the explanation of image pickup device 50, which is described in the first embodiment. The explanation thereof is omitted.

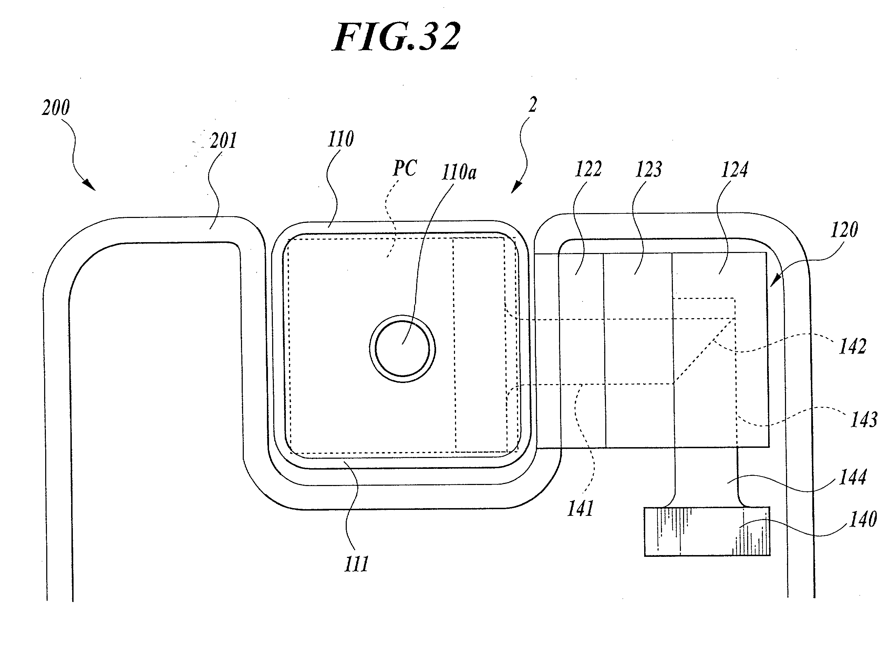

The flexible substrate 140 used as a communicating connection transmits the image information obtained by the image pickup element 151 to the outside of the image pickup unit 2. As shown in FIGS. 28 and 32, the flexible substrate 140 comprises the axial direction extension part 141 extending to the rotational axis direction of the case body 110 from the case body 110 to the rectangular holding part 120, the bent part 142 formed on an end portion of the axial direction extension part 141 to bend the flexible substrate 140 in the rectangular holding part 120 to a direction which is approximately perpendicular to the rotational axis direction, the circumferential direction extension part 143 extending to a circumferential direction of the rectangular holding part 120 from the end portion of the bent part 142 in the rectangular holding part 120, and the extending part 144 extending to the outside of the rectangular holding part 120 through the slit portion 121. In the second embodiment, by bending one flexible substrate 140 which extends to a predetermined direction, the axial direction extension part 141, the bent part 142, the circumferential direction extension part 143 and the extending part are formed. That is, among the communicating connection, at least a portion from the axial direction extension part 141 to the extending part 144 is made of the flexible substrate 140. In this case, the bent part 142 of the flexible substrate 140 is incorporated into the image pickup unit 2 after the flexible substrate 140 is gradually bent at the outside of the image pickup unit 2 so as not to apply a sharp load to the bent portion 142.

In the second embodiment, the axial direction extension part 141 approximately coincides with the rotational axis direction of the case body 110. The bent part 142 is bent so that the bent portion is formed at about 45° with respect to the rotational axis when the bent part 142 is seen from the upper side. The circumferential direction extension part 143 which is continuous to the bent part 142 is curved. The bent part 142 side of the circumferential direction extension part 143 extends to the circumferential direction in the substrate containing part 124c of the outer block body 124. The extending part 144 side of the circumferential direction extension part 43 extends to the circumferential direction along the inner surface of the rectangular holding part 120. The extending part 144 which is continuous to the circumferential direction extension part 143 is inserted into the slit portion 121 along the circumferential direction of the circular holding part 120.

The circumferential direction extension part 143 is formed so as to be wound in the substrate containing part 124c. By rotating the case body 110, the circumferential direction extension part 143 of the flexible substrate 140 is expanded in the substrate containing part 124c.

The extending part 144 of the flexible substrate 140 is arranged so that a width direction of the extending part 144 coincides with the rotational axis direction of the case body 110. The slit portion 121 of the circular holding part 120, into which the extending part 144 is inserted, is formed so as to extend the slit portion 121 to the rotational axis direction of the case body 110 in accordance with a width of the extending part 144.

In the image pickup unit 2 having the above-described structure, because the axial direction extension part 141 of the flexible substrate 140 is arranged in the case shaft part 113 which is pivotally supported by the rectangular holding part 120, the flexible substrate 140 can be guided to the outside by using the case shaft part 113 without forming a guide member or the like for guiding the flexible substrate 140 to the outside.

Because the image pickup unit 2 has a cantilever structure that the case body 110 is supported only by the rectangular holding part 120, as shown in FIG. 32, the image pickup unit 2 can be rotatably fixed to the electronic apparatus 200, such as a portable telephone, by fixing the main body 201 of the electronic apparatus 200 only to the rectangular holding part 120.

Because the rectangular holding part 120 is divided into a plurality of block bodies 122, 123 and 124, the case body 110 can be pivotally supported by the inner block body 122 which is the closest to the case body 110. The perpendicular direction extension part 143 of the flexible substrate 140 can be arranged in the other block bodies 123 and 124. In the second embodiment, as described above, the perpendicular direction extension part 143 is arranged in the substrate containing part 124c of the outer block body 124.

Further, it is possible to form the inner block body 122 so as to pivotally support the case body 110 and to form the slit portion 121 for the flexible substrate 140 in at least one of the other block bodies 123 and 124. In the second embodiment, as described above, the slit portion 121 is formed on the outer block body 124.

Because the perpendicular direction extension part 142 of the flexible substrate 140 is arranged in the outer block body 124 which is arranged most apart from the case body 110 in the rotational axis direction, it is possible to incorporate the outer block body 124 into the case body 110 side after the block bodies 122 and 123 except the outer block body 124 are incorporated into the case body 110 side in a state that the axial direction extension part 141 is inserted thereinto and the bent part 142 and the like of the flexible substrate 140 are contained in the predetermined position of the outer block body 124.

In this case, because the slit portion 121 of the outer block body 124 is open on the middle block body 123 side, it is possible to contain the circumferential direction extension part 143 in the substrate containing part 124c in a state that the bent part 142, the circumferential direction extension part 143, the extending part 144 and the like are previously formed by processing the flexible substrate 140, and then attach the outer block body 124 to the middle block body 123.

Further, because the axial direction extension part 141 of the flexible substrate 140 extends from the case body 110 to the outer block body 124 of the rectangular holding part 120 through a relatively long section, a torsion load per unit length, which is applied to the axial direction extension part 141 of the flexible substrate 140 by the rotating the case body 110, becomes small.

Because the case body 110 is held in each rotational position selectively, the case body 110 is not rotated in the image pickup. Further, the case body can be rotated so as to be directed to the photographic subject in accordance with the position of the photographic subject and the like.

Further, because the rotation regulating part 130 is provided on the connecting side of the rectangular holding part 120, which is connected with the case body 110, the interval between the rotation regulating part 130 and the case body 110 and the interval between the rotation regulating part 130 and the connecting portion of the rectangular holding part 120 becomes short. Thereby, the moment which is applied to the engaging plate 131 and the like of the rotation regulating part 130 when the force is applied to the connecting portion of the rectangular holding part 120 from the case body 110 by rotating the case body 110, can be reduced.

Further, when the ball 132 moves on the surface of the engaging plate 131 and is inserted into one engaging hole 134, the rotation of the case body 110 is regulated. In this case, when a force is applied to the case body 110 in a circumferential direction, the ball 132 is escaped from the engaging hole 134 against the biasing force of the coil spring 133 and moves on the engaging plate 131. Thereafter, when the ball 132 reaches the adjacent engaging hole 134, the ball 132 is inserted into the engaging hole 134 by the biasing force of the coil spring 133. In this case, the engaging plate 131 rotates with the case body 110 and is selectively engaged with the ball 132 provided on the rectangular holding part 120 side.

In this case, the ball 132 and the coil spring 133 are disposed in the rectangular holding part 120. When the rectangular holding part 120 is incorporated into the case body 110, the ball 132 and the coil spring 133 are incorporated into the image pickup unit 2 in a state that the ball 132 and the coil spring 133 are disposed in each block body 123 and 124.

The case body 110 is only rotated within the predetermined angular range by the rotation limiting part 160. In the second embodiment, one projecting portion 113b provided on the case shaft part 113 of the case body 110 moves in the rotation liming groove 123d formed on the middle block body 123 of the rectangular holding part 120. Thereby, the movement of the projecting portion 113b is limited by the both ends of the rotation limiting groove 123d.

The user or the like of the electronic apparatus 200 comprising the image pickup unit 2 can pick up an image of a photographic subject by rotating the case body 110 with respect to the rectangular holding part 120 fixed to the electronic apparatus 200 in accordance with the position of the photographic subject and the like.

Then, because the extending part 144 side of the flexible substrate 140 is expanded to a longitudinal direction by rotating the case body 110, a load, such as torsion, is not applied to the axial direction extension part 141 side. Because the flexible substrate 140 is arranged so that a width direction of the extending part 144 coincides with the rotational axis direction, a force, such as torsion, is not applied to the extending part 144 side. The flexible substrate is bent in a thickness direction in which the flexural rigidity is relatively small.

Because the circumferential direction extension part 143 is formed so as to be wound in the rectangular holding part 120 and the flexible substrate 140 is expanded in the rectangular holding part 120 by rotating the case body 110, the flexible substrate 140 is not expanded out of the rectangular holding part 120. Therefore, the position of the connecting end portion between the flexible substrate 140 and the processing part of the electronic apparatus 200 is not changed.

As described above, according to the image pickup unit 2 of the second embodiment and the electronic apparatus 200 having the above image pickup unit 2, because the flexible substrate 140 can be guided to the outside by using the case shaft part 113 without forming a guide member or the like for guiding the flexible substrate 140 to the outside, the image pickup unit 2 can be formed more freely. The case body 110 and the like can be easily formed. It is advantageous for design and manufacturing.

According to the image pickup unit 2 of the second embodiment and the electronic apparatus 200 having the above image pickup unit 2, because the image pickup unit 2 has a cantilever structure that the case body 2 is supported by only the rectangular holding part 120, the image pickup unit 2 is easily incorporated into the electronic apparatus 200. As compared with the image pickup unit in which the both sides of case body 110 are fixed to the electronic apparatus 200, the image pickup unit 2 and the electronic apparatus 200 to which the image pickup unit 2 is fixed, are designed more freely.

According to the image pickup unit 2 of the second embodiment and the electronic apparatus 200 having the above image pickup unit 2, because the image of a photographic subject can be picked up by rotating the case body 110, the user or the like is not required to move the image pickup unit 2 with the main body 201 of the electronic apparatus in the image pickup of the photographic subject. As a result, it is extremely advantageous for practical use.

According to the image pickup unit 2 of the second embodiment and the electronic apparatus 200 having the above image pickup unit 2, because the rectangular holding part 120 is divided into a plurality of block bodies 122, 123 and 124, the image pickup unit 2 can be assembled more freely. For example, after the inner block body 122 used as the closest block body is attached to the case body 110, the bent part 142 of the flexible substrate 140 is contained in the outer block body 124 which is one of the other block bodies and the outer block body 124 is incorporated into the inner block body 122 side. As a result, a worker or the like can easily assemble the image pickup unit.

According to the image pickup unit 2 of the second embodiment and the electronic apparatus 200 having the above image pickup unit 2, because it is possible to form the inner block body 122 so as to pivotally support the case body 110 and to form the slit portion 121 for the flexible substrate 140 in the outer block body 124, a member for pivotally supporting the case body 100 and the slit portion 121 are formed in each block body 122 and 124 separately. The rectangular holding part 120 can be extremely easily formed. It is possible to reduce the manufacturing cost.

According to the image pickup unit 2 of the second embodiment and the electronic apparatus 200 having the above image pickup unit 2, because the perpendicular direction extension part 142 of the flexible substrate 140 may be arranged in the outer block body 124 which is arranged most apart from the case body 110 in the rotational axis direction, it is possible to easily incorporate the outer block body 124 into the case body 110 side. Thereby, a worker or the like can easily assemble the image pickup unit.

According to the image pickup unit 2 of the second embodiment and the electronic apparatus 200 having the above image pickup unit 2, because a torsion load per unit length, which is applied to the axial direction extension part 141 of the flexible substrate 140 by the rotating the case body 110, becomes small, it is possible to improve the durability of the flexible substrate 140 exponentially.

According to the image pickup unit 2 of the second embodiment and the electronic apparatus 200 having the above image pickup unit 2, because the case body 110 is held in each rotational position selectively and is not rotated in the image pickup, it is possible to carry out the image pickup of the photographic subject clearly without causing a camera shake or the like in the image pickup. Further, because the case body can be rotated so as to be directed to the photographic subject in accordance with the position of the photographic subject and the like, it is extremely advantageous for practical use.

According to the image pickup unit 2 of the second embodiment and the electronic apparatus 200 having the above image pickup unit 2, because the rotation regulating part 130 is provided on the connecting side of the rectangular holding part 120, which is connected with the case body 110, the moment and the like which is applied to the engaging plate 131 and the like of the rotation regulating part 130, can be reduced. Therefore, the deformation of each part of the rotation regulating part 130 can be prevented. The durability of each part can be improved. It is possible to prevent a slight camera shake for a photographic subject or the like, which is caused by deforming each part in a state that the case body is held by the rotation regulating part 130.

According to the image pickup unit 2 of the second embodiment and the electronic apparatus 200 having the above image pickup unit 2, when the ball 132 moves on the surface of the engaging plate 131 and is inserted into one engaging hole 133, the rotation of the case body 110 is regulated. Therefore, it is possible that the case body 110 is rotated smoothly by moving the ball 132. Because the ball 132 is inserted into each engaging hole 133 selectively, it is possible to regulate the rotation of the case body 110 reliably.

According to the image pickup unit 2 of the second embodiment and the electronic apparatus 200 having the above image pickup unit 2, because the ball 132 and the coil spring 134 and the like are disposed in the rectangular holding part 120, when the rectangular holding part 120 is incorporated into the case body 110, the ball 132 and the coil spring 134 can be incorporated into the image pickup unit 2 in a state that the ball 132 and the coil spring 134 are disposed in each block body 123 and 124. Therefore, it is extremely advantageous for practical use.

According to the image pickup unit 2 of the second embodiment and the electronic apparatus 200 having the above image pickup unit 2, because the rotation limiting part 160 is provided, the case body 110 is not rotated extremely. A force, such as tension, compression or the like, is not applied to the extending part 144 of the flexible substrate 140 and the like. It is possible to improve the reliability of the flexible substrate 140 more. Because the movement of the projecting portion 113b is limited by the both ends of the rotation limiting groove 123d, the rotation of the case body 110 over the predetermined angular range can be reliably limited by the above simple structure.

According to the image pickup unit 2 of the second embodiment and the electronic apparatus 200 having the above image pickup unit 2, because the extending part 144 side of the flexible substrate 140 is expanded by rotating the case body 110, and a load, such as torsion, is not applied to the axial direction extension part 141 side, it is possible to reduce the load to be applied to the flexible substrate 140 and to improve the reliability of the flexible substrate 140 exponentially.

According to the image pickup unit 2 of the second embodiment and the electronic apparatus 200 having the above image pickup unit 2, because the flexible substrate 140 is arranged so that a width direction of the extending part 144 coincides with the rotational axis direction, the torsion force is not applied to the extending part 144. Thereby, it is possible to improve the reliability of the flexible substrate 140 exponentially. In particular, according to the second embodiment, a load, such as torsion or the like, is not applied to each part of the plate-like flexible substrate 140. In the image pickup unit in which the case body is rotated, the plate-like flexible substrate can be used. It is extremely advantageous for practical use. Further, because the extending part 144 of the flexible substrate 140 is bent in the thickness direction in which the flexural rigidity is relatively small, the flexible substrate 140 is allowed to be bent when the case body 110 is rotated. It is possible to rotate the case body 110 smoothly.

According to the image pickup unit 2 of the second embodiment and the electronic apparatus 200 having the above image pickup unit 2, because the flexible substrate 140 is expanded in the rectangular holding part 120 by rotating the case body 110, the position of the end portion of the extending part 144 of the flexible substrate 140 is not changed. It is not necessary that a processing part of the electronic apparatus 200, which is connected with the end portion of the extending part 144, has a structure which copes with the expansion of the flexible substrate 140. As a result, it is extremely advantageous when the electronic apparatus 200 having the image pickup unit 2 is designed.

In the second embodiment, the image information is transmitted by the flexible substrate 140. However, the image information may be transmitted by another communicating connection, for example, a transmission cable or the like.

In the first embodiment, the bent part 142 of the flexible substrate 140 is bent so as to be independent of the image pickup unit 2. However, a contact member for contacting with the bent part 142 may be provided in the substrate containing part 124c of the outer block body 124 and the bent part 142 of the flexible substrate 140 may be formed by contacting the flexible substrate 140 with the contact member to bend the flexible substrate 140. In this case, it is possible to bend the flexible substrate 140 by using the contact member and to form the bent part 142 adequately. Further, because the shape of the bent part 142 can be kept by the contact member, there is no possibility that the stress to be caused by deforming the bent part 142 in accordance with the rotation of the case body 110, is concentrated. Thereby, it is possible to improve the reliability of the flexible substrate 140 exponentially.

In the second embodiment, the axial direction extension part 141 approximately coincides with the rotational axis direction of the case body 110. However, the axial direction extension part may be formed apart from the rotational axis of the case body toward a radial direction of the rectangular holding part. In this case, the bent part is bent toward the rotational axis. The circumferential direction extension part is formed so as to be gently curved by using the space apart from the rotational axis. In this case, because the circumferential direction extension part of the flexible substrate is gently curved, a portion of the circumferential direction extending part, which is shapely curved, is not formed. The stress and the like are not concentrated on the specific portion of the circumferential direction extension part by rotating the case body. Therefore, it is possible to improve the reliability of the flexible connection more.

In the second embodiment, one slit portion 121 is formed on the circular holding part 120. One extending part 144 of the flexible substrate 140 is inserted into the slit portion 121. However, the rectangular holding part may comprise a plurality of slit portions and the flexible substrate may comprise a plurality of extending parts which are formed so as to correspond to each slit portion. In this case, the image information and the like obtained by the image pickup unit are transmitted to the outside of the rectangular holding part through a plurality of extending parts of the flexible substrate . That is, by a plurality of extending parts, quantities of image information and the like can be transmitted. Further, because the flexible substrate comprises a plurality of extending parts, a width of one extending part can be narrowed. The load to be applied to the extending parts extending in accordance with the rotation of the case body, can be dispersed.

In the second embodiment, the flexible substrate 140 is expanded in the rectangular holding part 120. However, the circumferential direction extension part may be fixed to an inner surface of the rectangular holding part by a double-sided tape or the like. The flexible substrate may be expanded to the outside of the rectangular holding part by rotating the case body 10. In this case, the flexible substrate is not expanded in the rectangular holding part. The circumferential direction extension part and the like of the flexible substrate, which are curved in the rectangular holding part, are not deformed by rotating the case body. Therefore, the load is not applied to the curved portion and the like of the flexible substrate. It is possible to improve the reliability of the flexible substrate more.

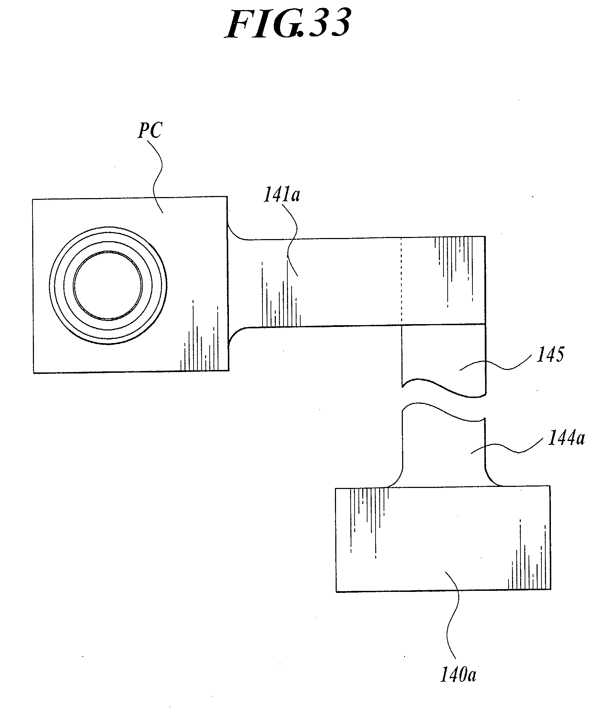

In the second embodiment, the communicating connection is formed by bending one flexible substrate 140. For example, as shown in FIG. 33, the communicating connection may be formed by connecting a plurality of flexible substrates. The flexible substrate 140a used as a communicating connection, comprises an axial direction extension part 141a which is the same as one shown in the second embodiment, a perpendicular direction extension part 145 connected with an end portion of the axial direction extension part 141a and extending to a direction which is approximately perpendicular to the rotational axis direction, and an extending part 144a which is the same as one shown in the second embodiment. The flexible substrate 140a is constituted of the different substrates which are separated into the axial direction extension part 141a side and the extending part 144a side. The end portion of the axial direction extension part 141a are jointed with the end portion of the perpendicular direction extension part 145.

In this case, the user or the like of the electronic apparatus 200 can pick up an image of a photographic subject by rotating the case body 110 with respect to the rectangular holding part 120 fixed to the electronic apparatus 200, in accordance with the position of the photographic subject and the like. Further, because the extending part 144a side of the flexible substrate 140a is expanded to a longitudinal direction by rotating the case body 110, a load, such as torsion, is not applied to the axial direction extension part 141a side. Further, in this case, the flexible substrate 140a can be easily formed by connecting the axial direction extension part 141a with the perpendicular direction extension part 145. Therefore, it is possible to reduce the manufacturing cost.

Further, in addition to the flexible substrate which is formed by joining a plurality of flexible substrate parts, the flexible substrate in which the axial direction extension part and the perpendicular direction extension part are unitedly formed, may be used. That is, the flexible substrate may be formed in an approximate L-shape. In this case, because the axial direction extension part and the perpendicular direction extension part are unitedly formed, the strength of the joint portion between the axial direction extension part and the perpendicular direction extension part can be improved exponentially. In this case, because the direction to which the communicating connection extends is changed by about 90° at the joint portion, the stress and the like is concentrated on the joint portion by rotating the case body. However, the joint portion is effectively strengthened against the stress and the like. Further, it is possible to improve the reliability of the communicating connection. Because the axial direction extension part and the perpendicular direction extension part of the communicating connection are unitedly formed, it is possible to reduce the manufacturing cost.

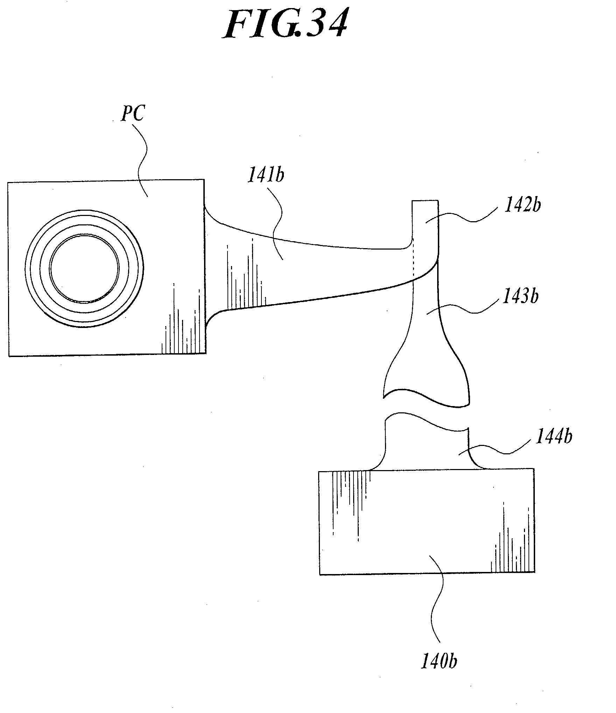

Further, in the second embodiment, the width of the flexible substrate 140 is not changed in a whole length. However, for example, as shown in FIG. 34, the width of the communicating connection 140b may be changed. In the communicating connection 140b, the width of the axial direction extension part 141b is gradually narrow toward the bent part 142b. The width of the circumferential direction extension part 143b made of a flexible substrate is gradually wide toward the extending part 144b. That is, among the communicating connection 140b, at least the circumferential direction extension part 143b is made of a flexible substrate. In this case, the load, such as torsion or the like, is not applied to each part (circumferential direction extension part 143b and the like) of the plate-like flexible substrate. In the image pickup unit in which the case body 110 is rotated, the plate-like flexible substrate can be used. It is extremely advantageous for practical use.

In the second embodiment, the rectangular holding part 120 used as a pivotally supporting part is divided into three block bodies 122, 123 and 124. As long as the rectangular holding part is divided into at least two block bodies, the image pickup unit can be assembled more freely like the second embodiment. A member for pivotally supporting the case body and the slit portion can be formed in each block body separately. Therefore, the rectangular holding part is extremely easily formed.

In the second embodiment, the engaging plate 131, the ball 132, the coil spring 133 and each engaging hole 134 constitute the rotation regulating part 130. However, as long as the case body is held in a plurality of rotational positions selectively, rotation regulating part may have any structure. Further, in the second embodiment, one projecting portion 113b, the rotation limiting groove 123d and the like constitute the rotation limiting part 160. As long as the rotation of the case body is limited to the predetermined angular range, the rotation limiting part may have any structure.

In the second embodiment, as an electronic apparatus 200 having an image pickup unit 2, a portable telephone is exemplified. However, the electronic apparatus may be a personal computer, a PDA, an AV equipment, a television, an electric home appliance, and other electronic apparatuses.

As long as the rectangular holding part 120 of the second embodiment is formed so as to be able to contain the communicating connection, it is not necessary that the rectangular holding part 120 is formed in a hollow quadratic prism. The shape of the case body 110 and the like can be modified within a scope of the present invention. Other concrete detail structures may be also modified.

As described above, according to the image pickup unit of the present invention, the communicating connection can be guided to the outside by using the case shaft part. The image pickup unit can be formed more freely. The case body and the like can be easily formed. It is advantageous for design and manufacturing.

Because the image pickup unit has a cantilever structure that the case body is supported by only the pivotally supporting part, the image pickup unit is easily incorporated into the electronic apparatus or the like. As compared with the image pickup unit in which the both sides of case body are fixed to the electronic apparatus or the like, the image pickup unit and the electronic apparatus or the like to which the image pickup unit is fixed, are designed more freely.

Because the case body of the image pickup unit can be rotated in accordance with the position of a photographic subject, the user or the like is not required to move the case body with the electronic apparatus or the like including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

By bending one connection part of the communicating connection, which extends to a predetermined direction, the axial direction extension part, the bent part and the extending part can be easily formed. Therefore, it is possible to reduce the manufacturing cost.

According to the image pickup unit of the present invention, the communicating connection can be guided to the outside by using the case shaft part. The image pickup unit can be formed more freely. The case body and the like can be easily formed. It is advantageous for design and manufacturing.

Because the image pickup unit has a cantilever structure that the case body is supported by only the pivotally supporting part, the image pickup unit is easily incorporated into the electronic apparatus or the like. As compared with the image pickup unit in which the both sides of case body are fixed to the electronic apparatus or the like, the image pickup unit and the electronic apparatus or the like to which the image pickup unit is fixed, are designed more freely.

Because the case body of the image pickup unit can be rotated in accordance with the position of a photographic subject, the user or the like is not required to move the case body with the electronic apparatus or the like including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

The communicating connection is easily formed by connecting the axial direction extension part with the perpendicular direction extension part. Therefore, it is possible to reduce the manufacturing cost.

According to the electronic apparatus of the present invention, because the case body of the image pickup unit can be rotated in accordance with the position of a photographic subject, the user or the like is not required to move the case body with the electronic apparatus including the image pickup unit in the image pickup of the photographic subject. As a result, it is extremely advantageous for practical use.

Further, because a load, such as torsion, is not applied to the axial direction extension part side, it is possible to reduce the load to be applied to the communicating connection by rotating the case body and to improve the reliability of the communicating connection exponentially.

### Third Embodiment:

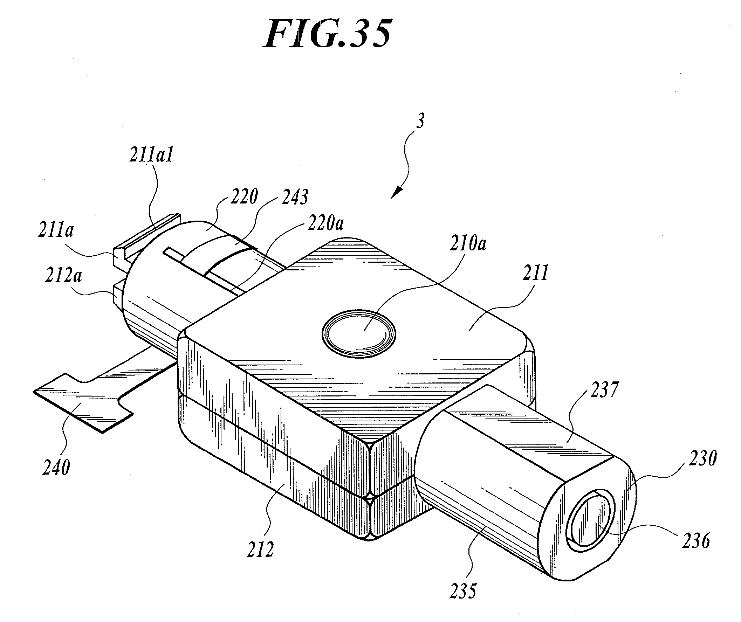

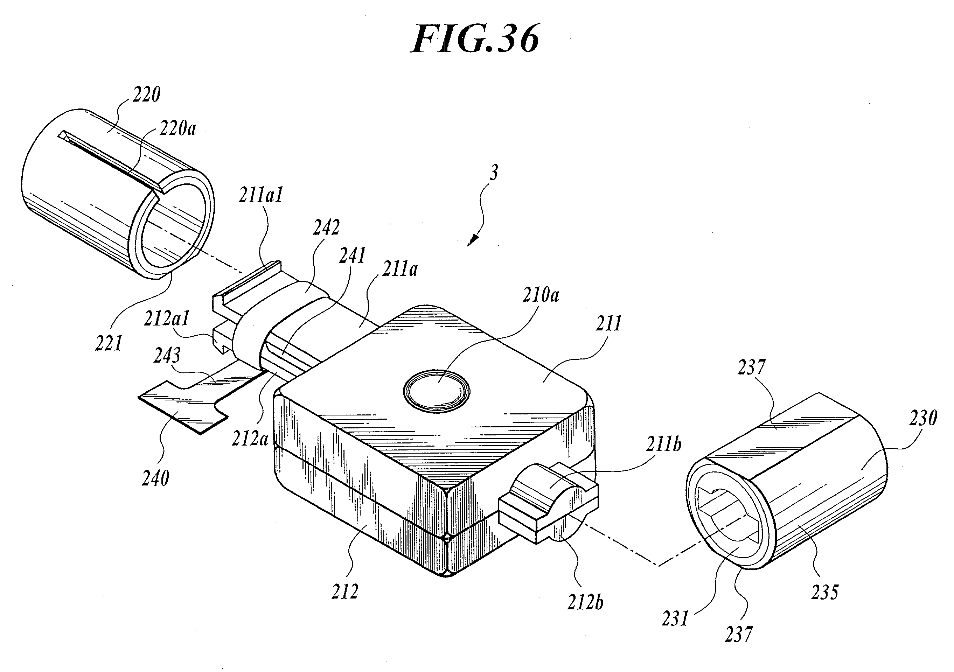

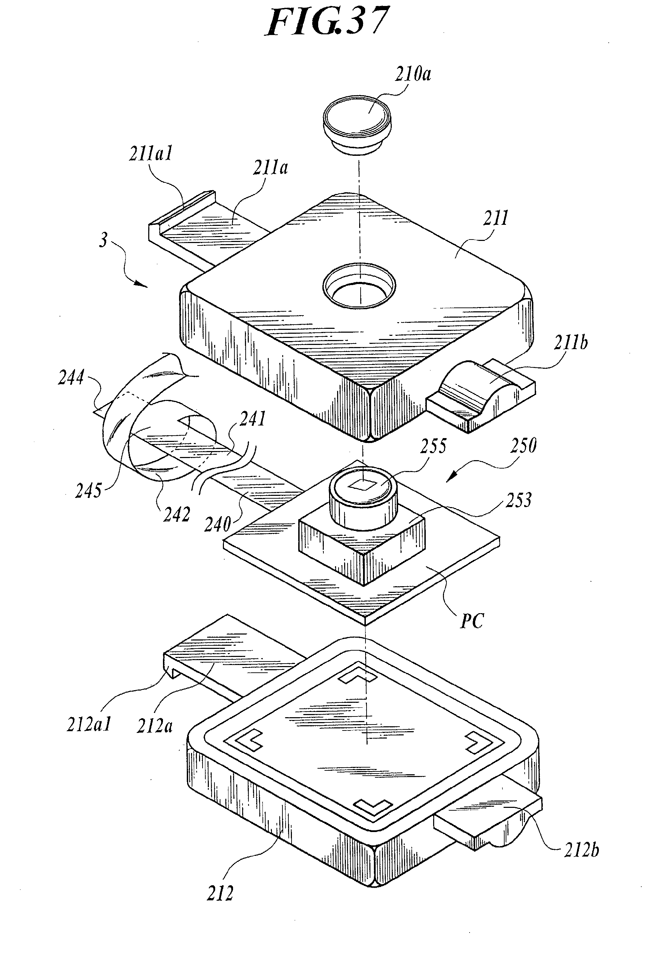

FIGS. 35 to 40 show the third embodiment according to the present invention. FIG. 35 is an external perspective view showing the image pickup unit. FIG. 36 is a partially exploded perspective view of the image pickup unit. FIG. 37 is a partially exploded perspective view of the image pickup unit.

As shown in FIGS. 35 to 37, the image pickup unit 3 comprises a case body 210 which contains a small image pickup device 250 for picking up an image of a photographic subject therein, and a pair of circular holding part 220 and rotational holding part 230 for pivotally supporting the case body 210, which are provided on right and left sides of the case body 210. As a communicating connection, a flexible substrate 240 connected with the small image pickup device 250, extends from the case body 210 to the outside of the device through the circular holding part 220 used as a pivotally supporting member. The image pickup unit 3 is provided in the electronic apparatus 300, such as a portable telephone or the like. The circular holding part 220 and the rotational holding part 230 are fixed to the main body 301 of the electronic apparatus so as to rotate the case body 210 with respect to the main body 301 of the electronic apparatus. The flexible substrate 240 extending from the image pickup unit 3 is connected with a processing part provided in the electronic apparatus 300.

As shown in FIGS. 36 and 37, the case body 210 comprises an upper case 211 having a translucent panel 210a directed to a photographic subject, and a lower case 212 to which the small image pickup device 250 is fixed. The upper case 211 and the lower case 212 comprises left rotational shaft members 211a and 212a extending toward the circular holding part 220 and right rotational shaft members 211b and 212b extending toward the rotational holding part 230, respectively. On each end portion of the left rotational shaft members 211a and 212a, pawl portions 211a1 and 212a1 for engaging with the left side portion of the circular holding part 220 so as to allow the case body 210 to rotate, are formed. The above-described flexible substrate 240 is arranged between the left rotational shaft members 211a and 212a. Each right rotational shaft member 211b and 212b is fixed to a rotational portion 231 which rotates with respect to a non-rotational portion 235 of the rotational holding part 230. That is, the case body 210 is supported by the circular holding part 220 and the rotational holding part 230 so as to be rotatable. In the third embodiment, the rotational holding part 230 has a positioning function for positioning the case body 210 at a predetermined rotational angle.

The explanation of the image pickup device 250 is approximately the same as the explanation of image pickup device 50, which is described in the first embodiment. The explanation thereof is omitted.

Next, the circular holding part 220 used as a pivotally supporting part is explained. As shown in FIGS. 35 and 36, the circular holding part 220 used as a pivotally supporting part is formed in an approximate cylindrical shape. Each left rotational shaft member 211a and 212a extending from the case body 210 is inserted into the circular holding part 220. Further, between the light rotational shaft member 211a and 212a, the flexible substrate 240 extending from the case body 210 is arranged. On the peripheral surface of the circular holding part 220, a slit portion 220a for guiding the flexible substrate 240 to the outside of the circular holding part 220 is formed. Further, on the outer peripheral surface of the circular holding part 220, a flat portion 221 having a shape in which a part of the peripheral surface is cut off, is formed.

The flat portion 221 contacts with a receiving portion 302 provided in the main body 301 of the electronic apparatus. Thereby, the circular holding part 220 is engaged with the electronic apparatus 300. The rotation of the circular holding part 220 with respect to the main body 301 of the electronic apparatus is regulated.

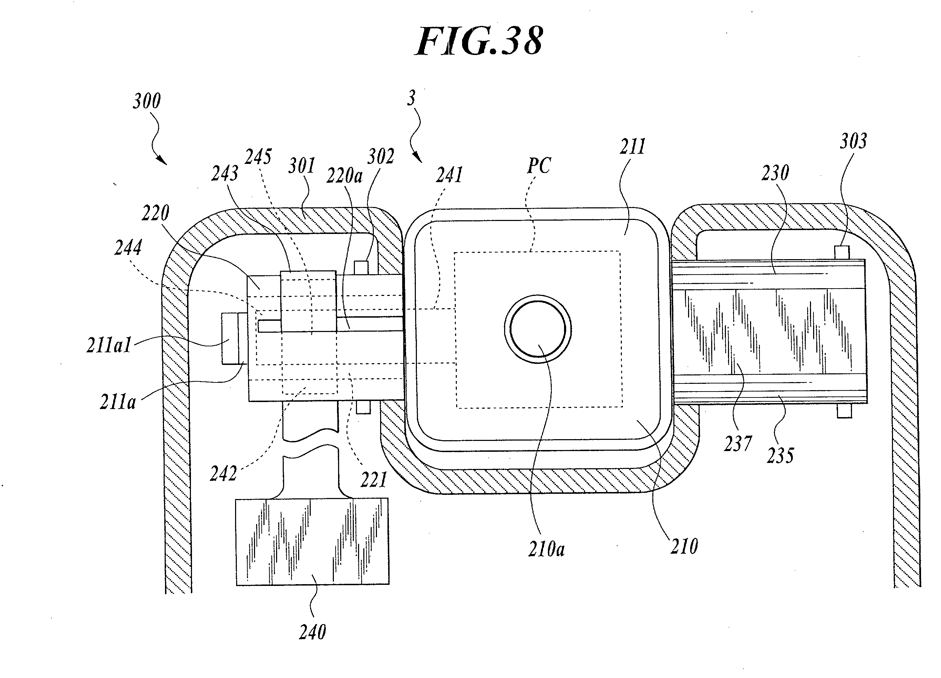

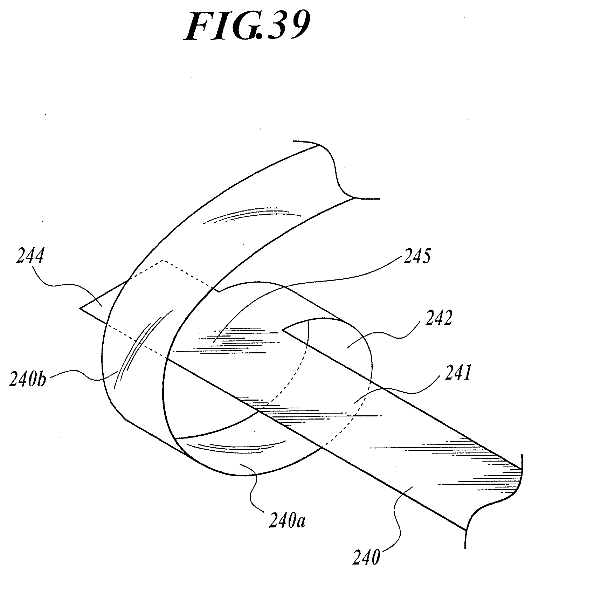

The flexible substrate 240 used as a communicating connection, comprises a wiring portion 240a made of metal, which is provided on one surface of the flexible substrate 240 and a strengthening portion 240b made of resin, which is provided on the other surface of the flexible substrate 240. The flexible substrate 240 transmits the image information obtained by the image pickup element 251 to the outside of the image pickup unit 3. As shown in FIGS. 38 and 39, the flexible substrate 240 comprises an axial direction extension part 241 extending to a rotational axis direction of the case body 210 from the case body 210 to the circular holding part 220, a circumferential direction extension part 242 extending to a circumferential direction of the circular holding part 220 in the circular holding part 220 from an end portion of the axial direction extension part 241 and an extending part 243 extending to the outside of the circular holding part 220 through the slit portion 220a.

As shown in FIG. 39, on the end portion of the axial direction extension part 241, a reinforcement extension part 244 extending to the rotational axis direction is formed. By the reinforcement extension part 244, the joint portion 245 between the axial direction extension part 241 and the circumferential direction extension part 242 of the flexible substrate 240 is reinforced. That is, in the third embodiment, the connection reinforcing member comprises the reinforcement extension part 244. Further, the reinforcement extension part 244 is formed on the flexible substrate 240 so as to unite the reinforcement extension part 244 with the axial direction extension part 241. In the third embodiment, by bending one flexible substrate 240 so as to be formed in an approximate T-shape, the axial direction extension part 241, the circumferential direction extension part 242, the extending part 243 and the reinforcement extension part 244 are formed. In this case, after the shape processing treatment, for example, a heat treatment or the like, is carried out outside the image pickup unit 3 so as to curve the circumferential direction extension part 242 of the flexible substrate 240, the circumferential direction extension part 242 is incorporated into the image pickup unit 3. In addition to the treatment carried out by a heat, the shape processing treatment may be a treatment carried out by a press or the like.

The circumferential direction extension part 242 is curved so that the wire portion 240a of the flexible substrate 240 is an inner surface and the strengthening portion 240b is an outer surface. In the third embodiment, the wire portion 240a of the flexible substrate 240 is made of copper foil or the like. The strengthening portion 240b is made of polyimide or the like. The extending part 243 which is continuous to the circumferential direction extension part 242 is inserted into the slit portion 220a along the circumferential direction. That is, the circumferential direction extension part 242 is formed so as to be wound in the circular holding part 220. By rotating the case body 210, the circumferential direction extension part 242 of the flexible substrate 240 is expanded in the circular holding part 220.

The extending part 243 of the flexible substrate 240 is arranged so that a width direction of the extending part 243 coincides with the rotational axis direction of the case body 210. The slit portion 220a of the circular holding part 220, into which the extending part 243 is inserted, is formed so as to extend the slit portion 220a to the rotational axis direction of the case body 210 in accordance with a width of the extending part 243.

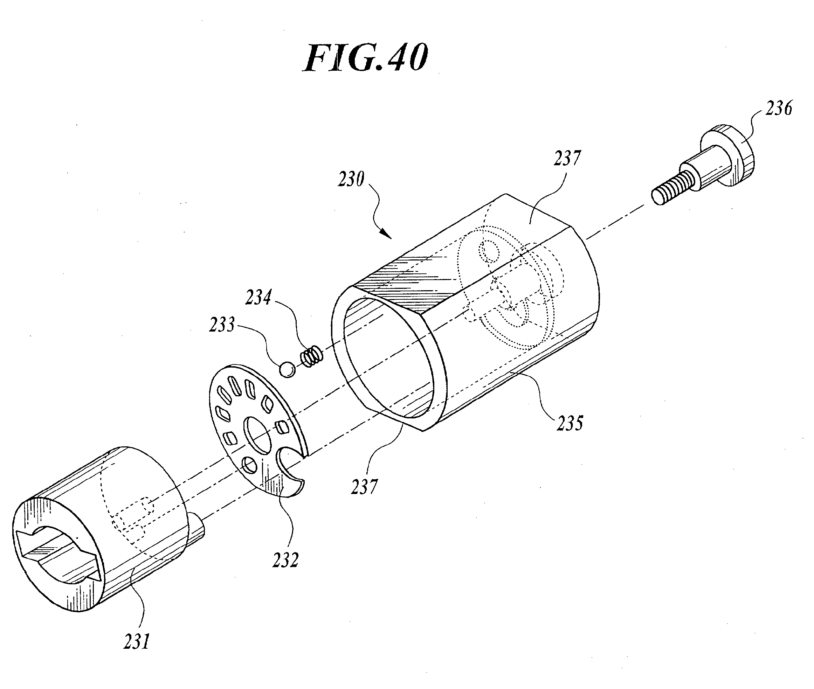

As shown in FIG. 40, the rotational holding part 230 is formed into an approximately cylindrical shape, and comprises a rotational portion 231 which is fitted to the right rotational shaft members 211b and 212b of the case body 210, an engaging plate 232 for rotating with the rotational portion 231 unitedly, an engaging member 233 for engaging with each hole portion 232a of the engaging plate 232 selectively, an elastic body 234 for biasing the engaging member 233 toward the engaging plate 232, a non-rotational portion 235 fixed to the main body 301 of the electronic apparatus, and a stepped screw 236 inserted into the engaging plate 232 and the non-rotational portion 235 and screwing the rotational portion 231. The rotational holding part 230 support the case body 210 so as to be rotatable.

The rotational portion 231 is formed in an approximate cylindrical shape and is engaged with the engaging plate 232 for covering a right opening of the rotational portion 231. The rotational portion 231 is screwed by the stepped screw 236 inserted into the engaging plate 232 and the non-rotational portion 235. Thereby, the rotational portion 231, the engaging plate 232 and the stepped screw 236 unitedly rotates with respect to the non-rotational portion 235.

In the engaging plate 232, a plurality of engaging holes are arranged in circumferential direction (in a direction of rotating the case body 210). The engaging member 233 is selectively engaged with each hole 232a. The rotational angle of the rotational portion 231 with respect to the non-rotational portion 235 is selectively determined. That is, the rotational angle of the case body 210 which rotates with the rotational portion 231 unitedly is also selectively determined.

The engaging member 233 is formed in an approximately ball shape, and is biased to the engaging plate 232 by the elastic body 234. That is, when the rotational force is applied to the case body 210 (rotational portion 231) in a state that the engaging member 233 is engaged with any one of the holes 232a, the engaging member 233 is escaped from the hole 232a against the biasing force of the elastic body 234, and moves on the engaging plate 232.

The elastic body 234 is a helical spring having a spiral shape is engaged in a predetermined position of the non-rotational portion 235. That is, the engaging member 233 and the elastic body 234 are always fixed to the non-rotational portion 235.

The non-rotational portion 235 almost constitutes the outer shape of the rotational holding portion 230 and is formed in an approximately cylindrical shape. On the outer peripheral surface of the non-rotational portion 235, two flat portions 237 are formed. Each flat portion 237 contacts with the receiving portion 303 provided in the main body 301 of the electronic apparatus. Thereby, the rotational holding part 230 is engaged with the electronic apparatus 300. The rotation of the rotational holding part 230 with respect to the main body 301 of the electronic apparatus is regulated.

In the image pickup unit 3 having the above-described structure, the user or the like of the electronic apparatus 300 can pick up an image of a photographic subject by rotating the case body 210 with respect to the circular holding part 220 fixed to the electronic apparatus 300 in accordance with the position of the photographic subject and the like.

As described above, according to the image pickup unit 3 of the third embodiment and the electronic apparatus 300 having the above image pickup unit 3, because it is possible to pick up an image of a photographic subject by rotating the case body 210, a user or the like is not required to move the image pickup unit 3 with the main body 301 of the electronic apparatus in the image pickup of the photographic subject. As a result, it is extremely advantageous for practical use.

According to the image pickup unit 3 of the third embodiment and the electronic apparatus 300 having the above image pickup unit 3,

According to the image pickup unit 3 of the third embodiment and the electronic apparatus 300 having the above image pickup unit 3, because the rigidity of the end portion of the axial direction extension part 241 is increased by the reinforcement extension part 244, the end portion can stand the force applied by the circumferential direction extension part 242 when the circumferential direction extension part 242 is expanded by rotating the case body. The torsion of the end portion of the axial direction extension part 241 can be prevented. In this case, because the direction to which the flexible substrate 240 extends is changed by about 90° at the joint portion 245 between the axial direction extension part 241 and the circumferential direction extension part 242, the stress is concentrated on the joint portion 245 by rotating the case body 210. However, the joint portion 245 is effectively strengthened against the stress and the like. Further, it is possible to improve the reliability of the flexible substrate 240 exponentially.

According to the image pickup unit 3 of the third embodiment and the electronic apparatus 300 having the above image pickup unit 3, because the reinforcement extension part 244 extends to the rotational axis direction from the end portion of the axial direction extension part 241, the torsional rigidity of the end portion of the axial direction extension part 241 is improved exponentially by the above extension portion of the reinforcement extension part 244. That is, the rigidity of the joint portion can be increased by the above simple structure.

According to the image pickup unit 3 of the third embodiment and the electronic apparatus 300 having the above image pickup unit 3, the reinforcement extension part 244 is formed so as to extend the axial direction extension part 241. That is, the end portion of the axial direction extension part 241 of the flexible substrate 240 is formed in an approximate T-shape. Thereby, it is possible to form the reinforcement extension part 244 easily, to unitedly form the axial direction extension part 241 and the reinforcement extension part 244 and to reduce the manufacturing cost.

According to the image pickup unit 3 of the third embodiment and the electronic apparatus 300 having the above image pickup unit 3, because the wiring portion 240a made of metal is an inner surface of the circumferential direction extension part 242 of the flexible substrate 240, it is possible to reduce the load of the curved flexible substrate 240. It is possible to obtain the reliability of the flexible substrate 240.

Because the wiring portion 240a of the flexible substrate 240 is an inner surface, the wiring portion 240a can be protected adequately. That is, in case that the outer surface of the flexible substrate 240 is slid on the inner peripheral surface of the circular holding part 220 by rotating the case body 210, because the strengthening portion 240b is slid, there is no possibility that the transmitting function of the flexible substrate 240 is troubled by damaging the wiring portion 240a.

According to the image pickup unit 3 of the third embodiment and the electronic apparatus 300 having the above image pickup unit 3, the load, such as torsion or the like, is not applied to each part of the plate-like flexible substrate 240. In the image pickup unit in which the case body is rotated, the plate-like flexible substrate can be used. It is extremely advantageous for practical use.

According to the image pickup unit 3 of the third embodiment and the electronic apparatus 300 having the above image pickup unit 3, because after the shape processing treatment is carried out outside the image pickup unit 3, the circumferential direction extension part 242 is incorporated into the image pickup unit 3, the flexible substrate 240 is easily attached to the circular holding part 220. Further, there is no possibility that the internal stress is generated in the flexible substrate 240 and the reliability for the durability of the flexible substrate 240 and the like is decreased like a flexible substrate which is curved by applying a force to a plate-shaped flexible substrate.

According to the image pickup unit 3 of the third embodiment and the electronic apparatus 300 having the above image pickup unit 3, because the flexible substrate 240 is expanded in the circular holding part 220 by rotating the case body 210, the position of the end portion of the extending part 243 side of the flexible substrate 240 is not changed. It is not necessary that a processing part of the electronic apparatus 300, which is connected with the end portion of the communicating connection on the extending part side, has a structure which copes with the expansion of the flexible substrate 240. As a result, it is extremely advantageous when the electronic apparatus 300 having the image pickup unit 3 is designed.

According to the image pickup unit 3 of the third embodiment and the electronic apparatus 300 having the above image pickup unit 3, because the flat portion 221 is formed on the outer peripheral surface of the circular holding part 220, by using the flat portion 221 of the circular holding part 220, the image pickup unit 3 can be easily fixed to or engaged with the main body 301 of electronic apparatus. That is, when the image pickup unit 3 is incorporated into the electronic apparatus 300, the position of the approximately cylindrical circular holding part 220 with respect to the main body 301 of the electronic apparatus can be precisely determined by using the flat portion 221 as a reference or the like.

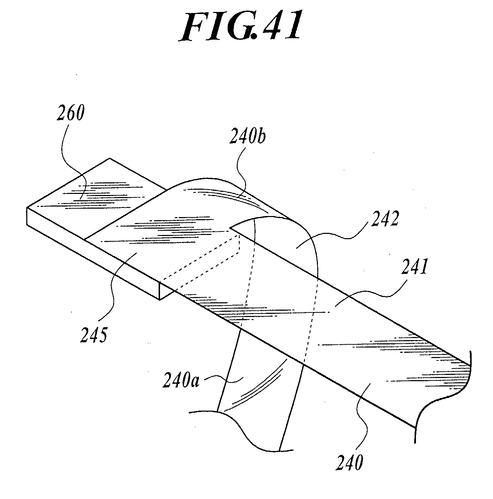

In the third embodiment, the reinforcement extension part 244 and the axial direction extension part 241 of the flexible substrate 240 are unitedly formed. However, as shown in FIG. 41, the connection reinforcing member may comprise a reinforcing portion 260 which is fixed to the end portion side of the axial direction extension part 241 of the flexible substrate 240. In FIG. 41, not the flexible substrate 240 having an approximate T-shape like the third embodiment, but the flexible substrate 240 having an approximate L-shape is shown. The reinforcing portion 260 is formed in a plate shape and is fixed to the joint portion 245 of the flexible substrate 240. Like the reinforcement extension part 244 of the third embodiment, the reinforcing portion 260 extends to the rotational axis direction from the axial direction extension part 241.

In this case, because the rigidity of the end portion of the axial direction extension part 241 is increased by the reinforcing portion 260, the torsional rigidity of the joint portion 245 between the axial direction extension part 241 and the circumferential direction extension part 242 is increased. Therefore, the rigidity of the joint portion 245 of the flexible substrate 240 can be locally increased effectively.

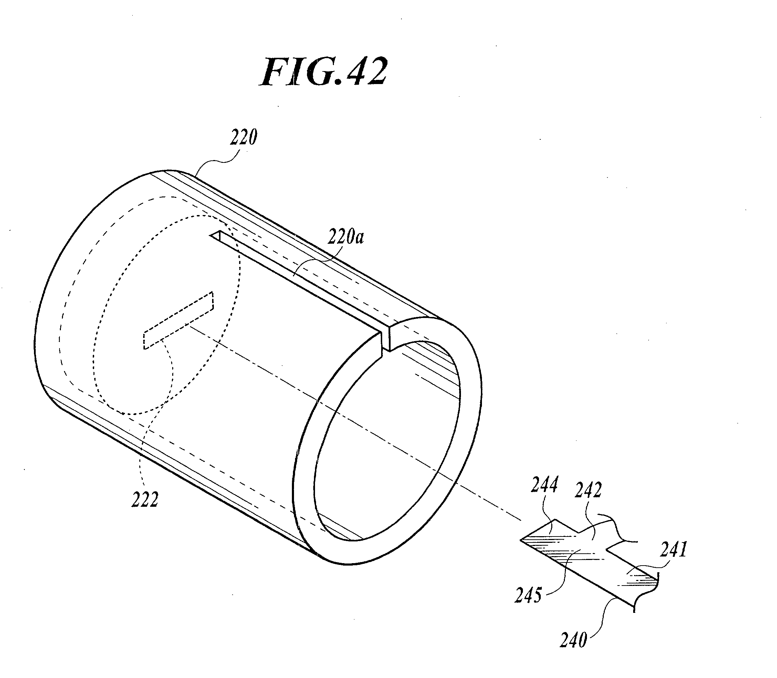

As shown in FIG. 42, a receiving portion 222 for receiving the reinforcement extension part 244 of the flexible substrate 240 may be formed on an inner surface of the circular holding part 220. FIG. 42 is an external perspective view of the circular holding part in a modified example of the third embodiment. The receiving portion 222 is formed in a hole extending to the width direction of the reinforcement extension part 244.

In this case, the same effect as the third embodiment can be obtained. Further, because the reinforcement extension part 244 extending from the end portion of the axial direction extension part 241 is received by the receiving portion 222 of the circular holding part 220, the reinforcement extension part 244 is supported by the receiving portion 244 and does not move in a radial direction when the force is applied to the axial direction extension part 241 from the circumferential direction extension part 242. Therefore, the reinforcement extension part 244 and the axial direction extension part 241 are not moved by rotating the case body 210. It is possible to prevent the torsion of the end portion of the axial direction extension part 241 adequately.

The reinforcement extension part 244 may be fixed to the circular holding part 220 by the receiving portion 222. The reinforcement extension part 244 is not required to be fixed to the receiving portion 222. In the former case, it is possible to fix the flexible substrate 240 adequately. In the latter case, it is possible to allow the flexible substrate 240 to move within a predetermined moving range.

### Fourth Embodiment:

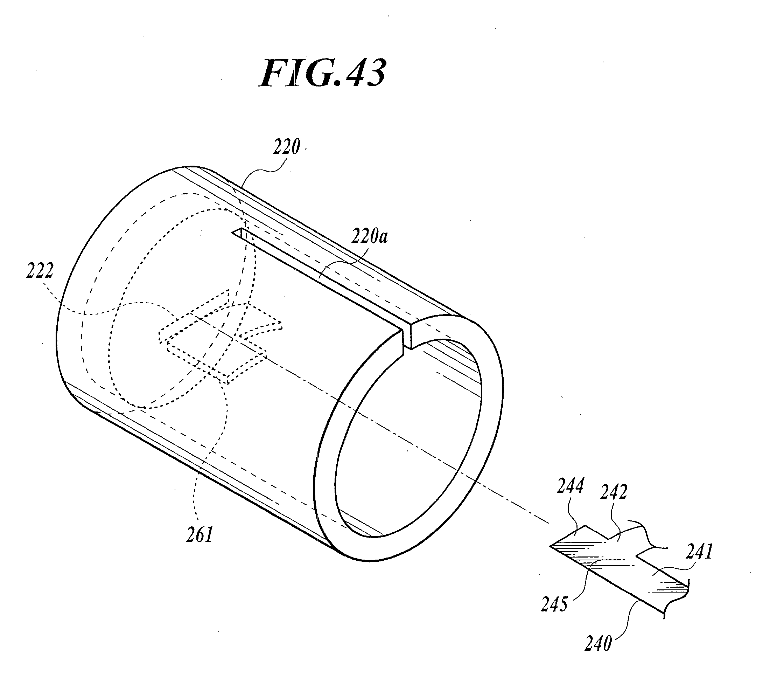

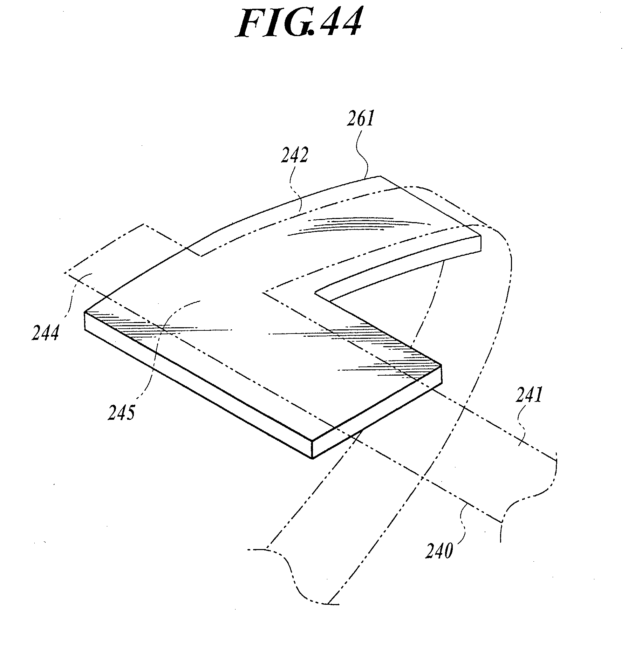

FIGS. 43 and 44 show the fourth embodiment according to the present invention. FIG. 43 is an external perspective view showing the circular holding part. FIG. 44 is an exploded perspective view of the flexible substrate. The fourth embodiment is different from the third embodiment in the structure that the receiving portion is formed in the circular holding part and that the guide member to which the flexible substrate is attached is provided in the circular holding part so as to project from the inner surface of the circular holding part. Hereinafter, the fourth embodiment will be explained by attaching the same reference numeral as the third embodiment to the same element as the third embodiment.

In the image pickup unit, the flexible substrate 240 is shaped in an approximate T-shape in the vicinity of the joint portion 245. As shown in FIG. 43, the receiving portion 222 for receiving the reinforcement extension part 244 is formed in the circular holding part 220. Because this receiving portion 222 is the same as the receiving portion 222 which is explained in the modified example of the third embodiment, the explanation of this receiving portion 222 is omitted. Further, in the circular holding part 220, a curved plate-like guide member 261 is provided so as to be adjacent to the receiving portion 222 and to project from the inner surface of the circular holding part 220.

As shown in FIG. 44, the guide member 261 is curved in the circumferential direction of the circular holding part 220. The flexible substrate 240 is attached to the guide member 261 around the joint portion 245. The guide member 261 is formed in an approximate L-shape. The end portion of the axial direction extension part 241 of the flexible substrate 240 formed in an approximate T-shape and the end portion of the inside of the circumferential direction extension part 242 are attached to the guide member 261.

That is, in the fourth embodiment, the connection reinforcing member comprises the reinforcement extension part 244, the receiving portion 222 for receiving the reinforcement extension part 244 and the guide member 261 to which the flexible substrate 240 is attached.

As described above, according to the image pickup unit of the fourth embodiment and the electronic apparatus having the above image pickup unit, the same effect as the third embodiment can be obtained. Further, by attaching the circumferential direction extension part 242 of the flexible substrate 240 to the guide member 261, the rigidity of the flexible substrate 240 is increased. In this case, because the end portion side of the circumferential direction extension part 242 of the flexible substrate 240 is attached to the guide member 261, the deformation, such as bending, is not caused on the end portion side of the circumferential direction extension part 242 by rotating the case body 210. Further, because the guide member 261 is formed in a curved plate shape, the flexible substrate 240 is curved along the guide member 261. Therefore, the flexible substrate 240 can be curved stably. The section in which the circumferential direction extension part 242 is attached to the guide member 261 may has any length as long as the flexible substrate 240 can be stably curved. In case that it is not required to fix the flexible substrate 240 strongly, it is preferable that the section is short to the utmost.

According to the image pickup unit of the fourth embodiment and the electronic apparatus having the above image pickup unit, because the reinforcement extension part 244 extending from the end portion of the axial direction extension part 241 is received by the receiving portion 222 of the circular holding part 220, the reinforcement extension part 244 is supported by the receiving portion 222 and does not move in a radial direction when the force is applied to the axial direction extension part 241 from the circumferential direction extension part 242. Therefore, the reinforcement extension part 244 and the axial direction extension part 241 are not moved by rotating the case body 210 . It is possible to prevent the torsion of the end portion of the axial direction extension part 241 adequately.

In the fourth embodiment, the guide member 261 is provided in the circular holding part 220 so as to project from the inner surface of the circular holding part 220. However, even though the guide member 261 is disposed separately from the circular holding part 220, the reinforcing effect for the joint portion 245 of the flexible substrate 240 can be obtained. Like the third embodiment, it is possible that the receiving portion 222 is not formed in the circular holding part 220.

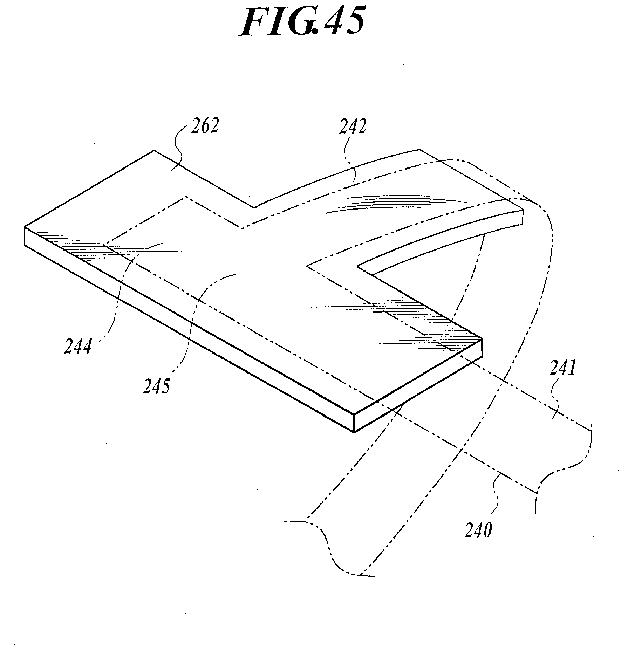

In the fourth embodiment, the guide member 261 is formed in an approximate L-shape. As shown in FIG. 45, the guide member 262 may be formed in an approximate T-shape. The guide member 262 is formed in a plate shape and is curved in the circumferential direction. The reinforcement extension part 244 of the flexible substrate 240 is attached to the guide member 262. In this case, the reinforcement extension part 244 of the flexible substrate 240 and a part of the guide member 262 are received by the receiving portion 222 of the circular holding part 220. In this case, like the above case, it is possible that the receiving portion 222 is not formed in the circular holding part 220.

In the fourth embodiment, the inner surface of the circumferential direction extension part 242 of the flexible substrate 240 is attached to the guide member 261. However, even though the outer surface of the circumferential direction extension part 242 is attached to the guide member, the same effect as the fourth embodiment can be obtained.

In the fourth embodiment, the flexible substrate 240 is formed in an approximate T-shape. However, the flexible substrate is formed in an approximate L-shape. Further, the end portion of the linear flexible substrate may be bent to form the circumferential direction extension part. The shape of the flexible substrate is not limited to the approximate T-shape.

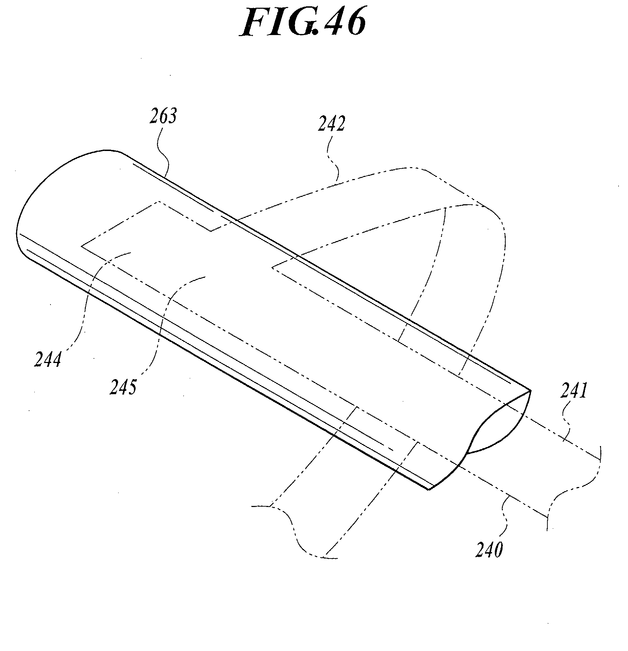

Further, the flexible substrate 240 may be attached to not the plate-like guide member 261 but the outer peripheral surface of the cylindrical guide member 263 as shown in FIG. 46. The guide member 263 extends to approximately the same direction as the axial direction extension part 241. The end portion of the axial direction extension part 241 is fixed in a longitudinal direction of the guide member 263. The circumferential direction extension part 242 is fixed in a circumferential direction of the guide member 263. In this case, the deformation, such as bending or the like, is not caused to the flexible substrate 240 by rotating the case body 210. The flexible substrate 240 can be curved stably.

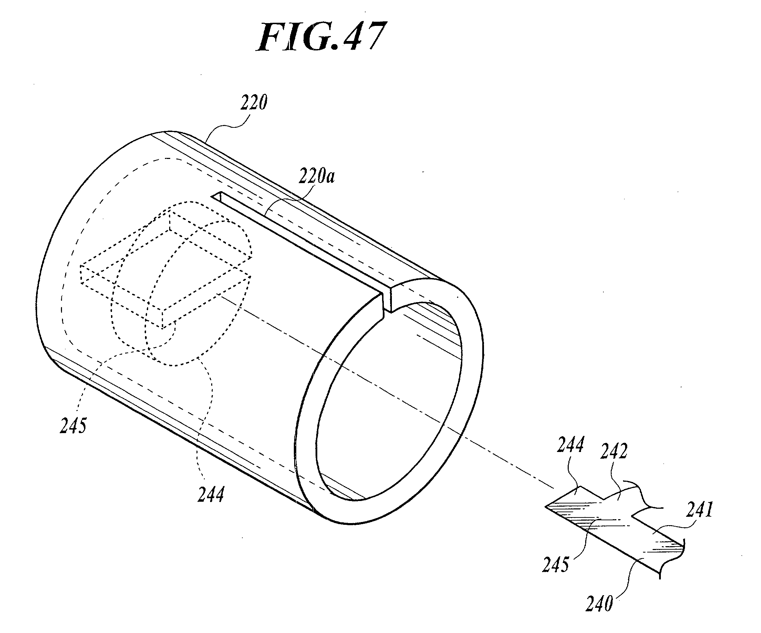

Further, as shown in FIG. 47, a cylindrical guide member 264 may be provided so as to project from the inner surface of the circular holding part 220. On the middle of the guide member 264, a notch 265 is formed as a receiving portion for receiving the axial direction extension part 241 of the flexible substrate 240. The notch 265 extends from the middle portion of the guide member 264 to the peripheral surface of the guide member 264. The circumferential direction extension part 242 of the flexible substrate 240 extends to the peripheral surface of the guide member 264 through the notch 265 and is attached to the outer peripheral surface of the guide member 264. Thereby, the deformation, such as bending or the like, is not caused to the flexible substrate 240 by rotating the case body 210. The flexible substrate 240 can be curved stably.

In the third and fourth embodiments, the image information is transmitted by the flexible substrate 240. However, the image information may be transmitted by another communicating connection, for example, a transmission cable or the like.

In the third and fourth embodiments, the flexible substrate 240 is expanded in the circular holding part 220. However, the circumferential direction extension part 242 may be fixed to an inner surface of the circular holding part 220 by a double-sided tape or the like. The flexible substrate 240 may be expanded to the outside of the circular holding part 220 by rotating the case body 210.

In the case body, the flexible substrate 240 is not expanded in the circular holding part 220. The circumferential direction extension part 242 and the like of the flexible substrate 240, which are curved in the circular holding part 220, are not deformed by rotating the case body 210. Therefore, the load is not applied to the curved portion and the like of the flexible substrate 240. It is possible to improve the reliability of the flexible substrate 240 more.

In the third and fourth embodiments, the communicating connection is formed by bending one flexible substrate 140. However, the communicating connection maybe formedby connecting a plurality of flexible substrates. Further, in the fourth embodiment, the width of the flexible substrate 240 is not changed in a whole length. However, the width of the communicating connection may be changed.

In the third and fourth embodiments, as an electronic apparatus 300 having an image pickup unit 3, a portable telephone is exemplified. However, the electronic apparatus may be a personal computer, a PDA, an AV equipment, a television, an electric home appliance, and other electronic apparatuses.

As long as the circular holding part 220 of the third and fourth embodiments is formed so as to be able to contain the communicating connection, it is not necessary that the circular holding part 220 is formed in a cylindrical shape. The shape of the case body 210 and the like can be modified within a scope of the present invention. Other concrete detail structures may be also modified.

As described above, according to the image pickup unit of the present invention, the user or the like of the image pickup unit is not required to move the image pickup unit with the electronic apparatus or the like in the image pickup of the photographic subject. As a result, it is extremely advantageous for practical use.

Further, it is possible to prevent the torsion of the end portion of the axial direction extension part, to reduce the load to be applied to the communicating connection and to improve the reliability of the communicating connection exponentially.

According to the electronic apparatus of the present invention, the user or the like of the image pickup unit is not required to move the image pickup unit with the electronic apparatus or the like in the image pickup of the photographic subject. As a result, it is extremely advantageous for practical use.

Further, it is possible to prevent the torsion of the end portion of the axial direction extension part, to reduce the load to be applied to the communicating connection and to improve the reliability of the communicating connection exponentially.

## Claims

1. An image pickup unit comprising:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a bent part formed on an end portion of the axial direction extension part to bend the communicating connection in the pivotally supporting part to a direction which is approximately perpendicular to the rotational axis direction; and an extending part extending to the outside of the pivotally supporting part through the slit portion.

2. The image pickup unit of claim 1; wherein the pivotally supporting part comprises a contact member for contacting with the bent part of the communicating connection; and
the bent part of the communicating connection is formed by contacting the communicating connection with the contact member to bend the communicating connection.

3. An image pickup unit comprising:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a perpendicular direction extension part connected with an end portion of the axial direction extension part and extending to a direction which is approximately perpendicular to the rotational axis direction; and an extending part extending to the outside of the pivotally supporting part through the slit portion.

4. The image pickup unit of claim 3; wherein the axial direction extension part and the perpendicular direction extension part are unitedly formed.

5. The image pickup unit of any one of claims 1 to 4; wherein the pivotally supporting part comprises a plurality of slit portions; and
the communicating connection comprises a plurality of extending parts which are formed so as to correspond to each slit portion.

6. The image pickup unit of any one of claims 1 to 5; wherein the slit portion is formed so as to extend to the rotational axis direction of the case body.

7. The image pickup unit of any one of claims 1 to 6; wherein the communicating connection comprises a circumferential direction extension part extending to a circumferential direction of the pivotally supporting part in the pivotally supporting part.

8. The image pickup unit of claim 7; wherein the axial direction extension part of the communicating connection is formed apart from the rotational axis of the case body toward a radial direction of the pivotally supporting part.

9. The image pickup unit of claim 7 or 8; wherein at least a portion of the circumferential direction extension part of the communicating connection is fixed to an inner surface of the pivotally supporting part; and
the communicating connection is expanded to the outside of the pivotally supporting part by rotating the case body.

10. The image pickup unit of claim 7 or 8; wherein the circumferential direction extension part of the communicating connection is formed so as to be wound in the pivotally supporting part; and
the communicating connection is expanded in the pivotally supporting part by rotating the case body.

11. The image pickup unit of any one of claims 7 to 10; wherein among the communicating connection, at least the circumferential direction extension part is made of a flexible substrate.

12. The image pickup unit of any one of claims 1 to 10; wherein among the communicating connection, at least a portion from the axial direction extension part to the extending part is made of a flexible substrate.

13. The image pickup unit of claim 12; wherein the flexible substrate is arranged so that a width direction of the extending part coincides with the rotational axis direction of the case body; and
the slit portion is formed so as to extend the slit portion to the rotational axis direction of the case body in accordance with a width of the extending part of the flexible substrate.

14. The image pickup unit of any one of claims 1 to 13; wherein the pivotally supporting part is formed in an approximately cylindrical shape; and
a flat portion is formed on the peripheral surface of the pivotally supporting part.

15. An image pickup unit comprising:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a case shaft part for arranging the communicating connection which extends to the outside of the case body;
a pivotally supporting part for pivotally supporting the case shaft part and for arranging the communicating connection extending from the case shaft part in the pivotally supporting part; and
a slit portion for guiding the communicating connection to an outside of the pivotally supporting part, the slit portion being formed on a peripheral surface of the pivotally supporting part;
wherein the image pickup unit has a cantilever structure that the case body is supported by only the pivotally supporting part; and
the communicating connection comprises an axial direction extension part extending to a rotational axis direction of the case body from the case body to the pivotally supporting part; a bent part formed on an end portion of the axial direction extension part to bend the communicating connection in the pivotally supporting part to a direction which is approximately perpendicular to the rotational axis direction; and an extending part extending to the outside of the pivotally supporting part through the slit portion.

16. An image pickup unit comprising:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a case shaft part for arranging the communicating connection which extends to the outside of the case body;
a pivotally supporting part for pivotally supporting the case shaft part and for arranging the communicating connection extending from the case shaft part in the pivotally supporting part; and
a slit portion for guiding the communicating connection to an outside of the pivotally supporting part, the slit portion being formed on a peripheral surface of the pivotally supporting part;
wherein the image pickup unit has a cantilever structure that the case body is supported by only the pivotally supporting part; and
the communicating connection comprises an axial direction extension part extending to a rotational axis direction of the case body from the case body to the pivotally supporting part; a perpendicular direction extension part connected with an end portion of the axial direction extension part and extending to a direction which is approximately perpendicular to the rotational axis direction; and an extending part extending to the outside of the pivotally supporting part through the slit portion.

17. The image pickup unit of claim 16; wherein the axial direction extension part and the perpendicular direction extension part are unitedly formed.

18. The image pickup unit of any one of claims 15 to 17; wherein the pivotally supporting part is divided into at least two block bodies arranged in the rotational axis direction of the case body.

19. The image pickup unit of claim 18; wherein the extending part side of the communicating connection is arranged in an outer block body which is arranged most apart from the case body in the rotational axis direction among the block bodies.

20. The image pickup unit of claim 18 or 19; wherein the pivotally supporting part comprises a rotation regulating mechanism for holding the case body in one position selected from a plurality of rotational positions.

21. The image pickup unit of claim 20; wherein the rotation regulating mechanism is provided on a connecting side of the pivotally supporting part, which is connected with the case body.

22. The image pickup unit of claim 20 or 21; wherein the rotation regulating mechanism comprises:
an engaging plate arranged so that a surface of the engaging plate is perpendicular to the rotational axis;
a plurality of engaging holes formed on the surface of the engaging plate and arranged in a direction of rotating the case body;
a ball body moving on the surface of the engaging plate by rotating the case body and inserted into one hole selected from the plurality of engaging holes; and
a biasing member for biasing the ball body toward the engaging plate.

23. The image pickup unit of claim 22; wherein the engaging plate is fixed to the case shaft part of the case body; and
the ball body and the biasing member are provided on the pivotally supporting part side.

24. The image pickup unit of claim 23; wherein the pivotally supporting part is divided into three block bodies which are arranged in the rotational axis direction in order of an inner block body, a middle block body and an outer block body from the case body side;
the case shaft part is pivotally supported by the inner block body; and
the ball body and the biasing member are provided on the middle block body side.

25. The image pickup unit of any one of claims 22 to 24; further comprising a rotation limiting mechanism for rotating the case body within a predetermined angular range.

26. The image pickup unit of claim 25; wherein the rotation limiting mechanism comprises:
a projecting portion provided on the case shaft part of the case body; and
a rotation limiting groove into which the projecting portion is inserted, and which extends to the direction of rotating the case body within the predetermined angular range.

27. The image pickup unit of any one of claims 15 to 26; wherein the communicating connection comprises a circumferential direction extension part extending to a circumferential direction of the pivotally supporting part in the pivotally supporting part.

28. The image pickup unit of claim 27; wherein among the communicating connection, at least the circumferential direction extension part is made of a flexible substrate.

29. The image pickup unit of any one of claims 15 to 27; wherein among the communicating connection, at least a portion from the axial direction extension part to the extending part is made of a flexible substrate.

30. An image pickup unit comprising:
an image pickup substrate having an image pickup element;
a case body for containing the image pickup substrate therein;
a communicating connection for transmitting image information obtained by the image pickup element to an outside of the case body, the communicating connection being connected with the image pickup substrate;
a pivotally supporting part for pivotally supporting the case body and for arranging the communicating connection extending from the case body in the pivotally supporting part; and
a slit portion for guiding the communicating connection to an outside of the pivotally supporting part, the slit portion being formed on a peripheral surface of the pivotally supporting part;
wherein the communicating connection comprises an axial direction extension part extending to a rotational axis direction of the case body from the case body to the pivotally supporting part; a circumferential direction extension part extending to a circumferential direction of the pivotally supporting part in the pivotally supporting part from an end portion of the axial direction extension part; and an extending part extending to the outside of the pivotally supporting part through the slit portion; and
a connection reinforcing member for reinforcing a joint portion between the axial direction extension part and the circumferential direction extension part is provided on the communicating connection.

31. The image pickup unit of claim 30; wherein the connection reinforcing member is provided on the end portion of the axial direction extension part so as to extend to the rotational axis direction.

32. The image pickup unit of claim 31; wherein the a receiving portion for receiving the connection reinforcing member is formed in the pivotally supporting part.

33. The image pickup unit of claim 31 or 32; wherein the connection reinforcing member comprises a reinforcement extension part which is formed on the communicating connection so as to unite the reinforcement extension part with the axial direction extension part.

34. The image pickup unit of any one of claims 31 to 33; wherein the connection reinforcing member comprises a reinforcing portion which is fixed to the end portion side of the axial direction extension part of the communicating connection.

35. The image pickup unit of any one of claims 30 to 34; wherein the communicating connection is made of a flexible substrate.

36. The image pickup unit of claim 35; wherein the flexible substrate comprises a wiring portion made of metal, the wiring portion being provided on one surface of the flexible substrate and a strengthening portion made of resin, the strengthening portion being provided on the other surface of the flexible substrate; and
the circumferential direction extension part is curved so that the one surface of the flexible substrate is an inner surface of the curved circumferential direction extension part.

37. The image pickup unit of claim 35 or 36; wherein the connection reinforcing member comprises a curved plate-shaped guide member; and
at least an end portion side of the circumferential direction extension part of the flexible substrate is attached to the guide member.

38. The image pickup unit of claim 35 or 36; wherein the connection reinforcing member comprises a guide member formed into a cylindrical shape; and
at least an end portion side of the circumferential direction extension part of the flexible substrate is attached to an outer peripheral surface of the guide member.

39. The image pickup unit of claim 37 or 38; wherein the guide member projects into an inner surface side of the pivotally supporting part.

40. The image pickup unit of any one of claims 30 to 39; wherein a shape processing treatment is carried out for the circumferential direction extension part so as to be curved.

41. An electronic apparatus comprising:
the image pickup unit of any one of claims 1 to 40; and
a processing part which is connected with the communicating connection and to which the image information is transmitted.
